(19) Europäisches Patentamt
European Patent Office
Office européen des brevets

(11) **EP 2 416 214 A1**

(12) **EUROPEAN PATENT APPLICATION**
published in accordance with Art. 153(4) EPC

(43) Date of publication:
08.02.2012 Bulletin 2012/06

(51) Int Cl.:
*G02F 1/135* (2006.01)    *G02F 1/133* (2006.01)
*G02F 1/1333* (2006.01)    *G06F 3/041* (2006.01)
*G09F 9/30* (2006.01)    *G09G 3/20* (2006.01)
*G09G 3/36* (2006.01)

(21) Application number: 09843062.2

(22) Date of filing: 27.10.2009

(86) International application number:
PCT/JP2009/068399

(87) International publication number:
WO 2010/116556 (14.10.2010 Gazette 2010/41)

(84) Designated Contracting States:
AT BE BG CH CY CZ DE DK EE ES FI FR GB GR HR HU IE IS IT LI LT LU LV MC MK MT NL NO PL PT RO SE SI SK SM TR

(30) Priority: 30.03.2009 JP 2009083447

(71) Applicant: Sharp Kabushiki Kaisha
Osaka-shi, Osaka 545-8522 (JP)

(72) Inventors:
• MURAI, Atsuhito
c/o Sharp Kabushiki Kaisha
Osaka-shi, Osaka 545-8522 (JP)
• KATAOKA, Yoshiharu
c/o Sharp Kabushiki Kaisha
Osaka-shi, Osaka 545-8522 (JP)

• WATANABE, Takuya
c/o Sharp Kabushiki Kaisha
Osaka-shi, Osaka 545-8522 (JP)
• IMAI, Hajime
c/o Sharp Kabushiki Kaisha
Osaka-shi, Osaka 545-8522 (JP)
• KITAGAWA, Hideki
c/o Sharp Kabushiki Kaisha
Osaka-shi, Osaka 545-8522 (JP)

(74) Representative: Goddar, Heinz J. et al
Forrester & Boehmert
Pettenkoferstrasse 20-22
80336 München (DE)

(54) **DISPLAY DEVICE AND METHOD OF OPERATION THEREOF**

(57)    A display device includes, in a display region, a first circuit including a photodiode (62b), a first capacitor (62c), a second capacitor (62d), and an output amplifier (62a). A cathode of the photodiode (62b), one end of the first capacitor (62c), one end of the second capacitor (62d), and an input of the output amplifier (62a) are connected with one another via a first node (netA). An electrode at the other end of the second capacitor (62d) is provided on a substrate having a display surface of a display panel, and an electrode at the one end of the second capacitor (62d) is positioned to be away from the display surface in a thickness direction of the display panel in such a manner as to face the electrode at the other end of the second capacitor (62d).

FIG.1

EP 2 416 214 A1

**Description**

Technical Field

The present invention relates to a display device including an optical sensor and a touch sensor in a display region.

Background Art

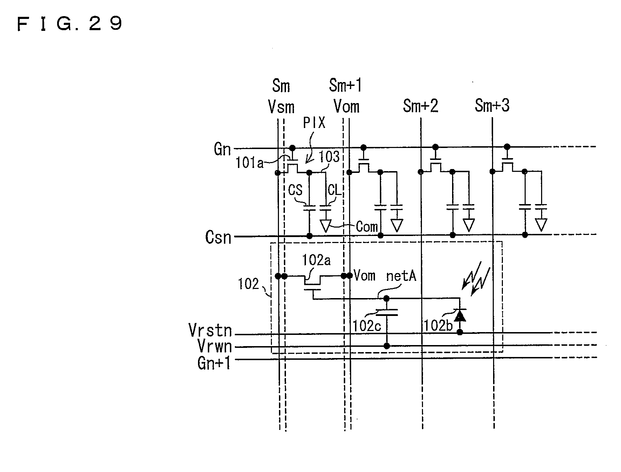

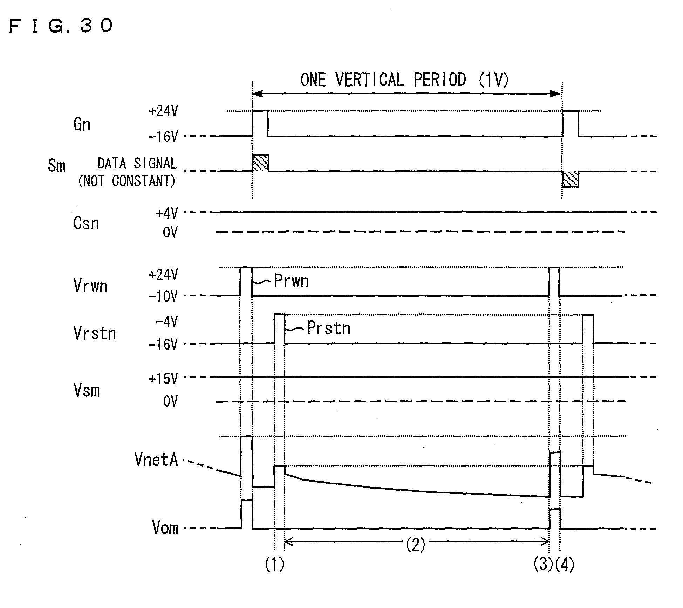

There have been known liquid crystal display devices having optical sensors in picture elements or pixels (see Patent Literature 1 for example). A configuration of such a liquid crystal display device is explained with reference to Fig. 29.
Fig. 29 shows a configuration of an n-th row in a display region of a liquid crystal display panel. The configuration of the n-th row includes a gate line Gn, source lines S (in the drawing, Sm to Sm+3 are shown), a plurality of picture elements PIX comparted by a retention capacitor line Csn, and at least one optical sensor circuit 102 connected with a reset line Vrstn and a read control line Vrwn. "n" and "m" at the end of a sign indicate a row number and a column number, respectively.
Each picture element PIX includes a TFT 101a serving as a selection element, a liquid crystal capacitor CL, and a retention capacitor CS. A gate of the TFT 101a is connected with the gate line Gn, a source of the TFT 101a is connected with the source line S, and a drain of the TFT 101a is connected with a picture element electrode 103. The liquid crystal capacitor CL is a capacitor formed by positioning a liquid crystal layer between the picture element electrode 103 and a common electrode Com. The retention capacitor CS is a capacitor formed by positioning an insulating film between the picture element electrode 103 or the drain electrode of the TFT101a and the retention capacitor line Csn. Constant voltages for example are applied to the common electrode Com and the retention capacitor line Csn.
The optical sensor circuit 102 is provided in any number. For example, the optical sensor circuit 102 may be provided with respect to one picture element PIX or one pixel (e.g. a set of picture elements PIX corresponding to R, G, B, respectively). The optical sensor circuit 102 includes a TFT 102a, a photodiode 102b, and a capacitor 102c. A gate of the TFT 102a is connected with an electrode called a node net A, a drain of the TFT 102a is connected with one source line S (here, Sm), and a source of the TFT 102a is connected with another one source line S (here, Sm+1). An anode of the photodiode 102b is connected with the reset line Vrstn and a cathode of the photodiode 102b is connected with the node net A. One end of the capacitor 102c is connected with the node net A and the other end of the capacitor 102c is connected with the read control line Vrwn.
During a period other than a period in which a data signal is written into the picture element PIX, the optical sensor circuit 102 causes a voltage appearing at the node net A in accordance with intensity of light incident to the photodiode 102b to be outputted as a sensor output voltage Vom via the source of the TFT 102a so that the sensor output voltage Vom is outputted via the source line S connected with the source of the TFT 102a (this source line S serves as a sensor output line Vom when detecting light (for convenience of explanation, the sensor output line and the sensor output voltage are given the same reference sign)) to a sensor read circuit outside the display region. At that time, the TFT 102a serves as a source follower. Further, at that time, the source line S connected with the drain of the TFT 102a serves as a power source line Vsm to which a constant voltage is applied when light is detected. Alternatively, the sensor output line Vom and the power source line Vsm may be provided independently of the source lines S as shown by broken lines close to the source lines S.
With reference to Fig. 30, the following details the operation of the optical sensor circuit 102.
During a writing period in which a data signal is written, a gate pulse consisting of +24V High level and -16V Low level is outputted as a scanning signal to the gate line Gn, and data signals are outputted to the source lines S. A constant voltage (e.g. +4V) is applied to the retention capacitor line Csn. This operation is repeated with respect to picture elements PIX in each row per one vertical period (1V). Other than the writing period, the result of light detection by the optical sensor circuit 102 can be outputted to the sensor read circuit.
At a time (1), when a reset pulse Prstn consisting of - 4V High level and -16V Low level for example is applied from an outside sensor drive circuit to the reset line Vrstn, the photodiode 102b gets conductive in a forward direction, and a voltage at the node netA is reset to a voltage at the reset line Vrstn. Thereafter, during a period (2), a leakage occurs in accordance with intensity of light incident to the photodiode 102b in a reverse biased state, so that the voltage at the node net A drops at a rate corresponding to the light intensity.
At a time (3), when a read pulse Prwn consisting of +24V High level and -10V Low level for example is applied from the sensor drive circuit to the read control line Vrwn, the voltage at the node netA increases. At that time, the voltage at the node netA goes beyond a threshold voltage of the TFT 102a. The sensor output voltage Vom outputted from the source of the TFT 102a while the read pulse Prwn is applied corresponds to the voltage at the node netA, i.e. corresponds to the light intensity. Accordingly, by the sensor read circuit reading the sensor output voltage Vom via the sensor output line Vom, it is possible to detect the light intensity. The optical sensor circuit 102 ends the output at a time (4), and stops its operation until next reset operation.

Citation List

[Patent Literature]

[Patent Literature 1]

International Publication No. 2007/145347 (published on December 21, 2007)

Summary of Invention

Technical Problem

However, a conventional display device including an optical sensor circuit in a display region suffers various problems when the display device is designed to include a touch sensor function as well.
For example, if such a conventional display device is designed to optically distinguish a pressed state of a display surface from a non-pressed state of the display surface based on shadows or reflections detected by a light detection function of the optical sensor circuit, even approaching fingers or styluses make shadows on the display surface, which deteriorates the accuracy in distinguishing the pressed state from the non-pressed state. Further, outside light is likely to cause malfunctions.
Further, if such a conventional display device is designed such that an electrostatic capacitor touch panel or a resistive film touch panel is externally added, another panel is layered on a display surface of a liquid crystal panel etc., so that display luminance drops or the panel as a whole is thickened. Further, the externally added touch panel increases the cost.
Further, if such a conventional display device is designed such that the electrostatic capacitor touch panel or the resistive film touch panel is provided adjacently in an in-plane direction to a region where the optical sensor circuit is provided, the cost for LSI to provide panels with different circuit configurations in the same layer increases, and an open area ratio in the display region drops.
As described above, a conventional display device including an optical sensor circuit in a display region suffers problems such as the display device cannot be designed to include a low-priced and highly reliable touch panel function without deteriorating a display function.
The present invention was made in view of the foregoing problems. An object of the present invention is to realize a display device including a low-priced, downsized, and highly reliable touch panel function without deteriorating a display function and to realize a method for driving the display device.

Solution to Problem

In order to solve the foregoing problems, a display device of the present invention includes, in a display region, a first circuit including a photodiode, a first capacitor, a second capacitor, and an output amplifier, a cathode of the photodiode, one end of the first capacitor, one end of the second capacitor, and an input of the output amplifier being connected with one another via a first node, an electrode at the other end of the second capacitor being provided on a substrate having a display surface of a display panel, and an electrode at the one end of the second capacitor being positioned to be away from the display surface in a thickness direction of the display panel in such a manner as to face the electrode at the other end of the second capacitor.
With the invention, capacitance of the second capacitor changes since application of a pressure to the display surface causes a change of the electrode at the other end of the second capacitor and the distance between the electrode at the one end and the electrode at the other end of the second capacitor changes. Consequently, the second capacitor serves as a detection element of a touch sensor, and the first circuit serves as a touch sensor. When using the first circuit as an optical sensor, leakage in the photodiode in accordance with intensity of light incident to the photodiode is detected. When using the first circuit as a touch sensor, the photodiode is made conductive in a forward direction and then a voltage is applied to the electrode of the other end of the first capacitor so that a reverse biased voltage is applied to the photodiode, and an output according to the voltage at the first node is obtained from the output amplifier.
Therefore, it is possible to realize a display device including a low-priced, downsized, and highly reliable touch panel function without deteriorating a display function.
In order to solve the foregoing problems, a display device of the present invention includes, in a display region, a first circuit including a photodiode, a first capacitor, a second capacitor, and an output amplifier, a cathode of the photodiode, one end of the first capacitor, one end of the second capacitor, and an input of the output amplifier being connected with one another via a first node, an electrode at the other end of the second capacitor being provided on a substrate having a display surface of a display panel, an electrode at the one end of the second capacitor being positioned to be away from the display surface in a thickness direction of the display panel in such a manner as to face the electrode at the other end of the second capacitor, a first direct voltage being applied to an anode of the photodiode, application of the first direct voltage to the anode during a first period making the photodiode conductive in a forward direction, while the first direct voltage is applied to the anode during a second period following the first period, a second pulse being applied to the other end of the first capacitor to change a voltage at the first node so that a reverse biased voltage is applied to the photodiode, and while the second pulse is applied, an output from the output amplifier being obtained.

With the invention, capacitance of the second capacitor changes since application of a pressure to the display surface causes a change of the electrode at the other end of the second capacitor and the distance between the electrode at the one end and the electrode at the other end of the second capacitor changes. Consequently, the second capacitor serves as a detection element of a touch sensor, and the first circuit serves as a touch sensor. The first direct voltage is applied to the anode of the photodiode, and application of the first direct voltage during the first period makes the photodiode conductive in a forward direction, so that the voltage at the first node is substantially equal to the first direct voltage.

During the second period, while the first direct voltage is applied to the anode, the second pulse is applied to the other end of the first capacitor to change the voltage at the first node so that a reverse biased voltage is applied to the photodiode. At that time, the voltage at the first node is determined depending on a ratio in capacitance of the first capacitor to the second capacitor. Capacitance of the first capacitor is not changed by application of a pressure, but capacitance of the second capacitor is changed. Accordingly, the output voltage changes in accordance with capacitance of the second capacitor. Since the output of the output amplifier is obtained while the second pulse is applied, it is possible to detect whether a pressure is applied to the display surface or not.

The detection of the applied pressure is made while the second pulse is applied. Accordingly, even if light is incident to the photodiode, there is little possibility that leakage in the photodiode in a reverse biased state changes the voltage at the first node. Therefore, it is possible to prevent the incident light from being a noise which changes the voltage at the first node in the pressure detection operation.

Therefore, it is possible to realize a display device including a low-priced, downsized, and highly reliable touch panel function without deteriorating a display function. Further, since the first direct voltage is not a pulse but a DC voltage, it is unnecessary to determine timing. Thus, setting of timing is further easier.

In order to solve the foregoing problems, a display device of the present invention includes, in a display region, a first circuit including a photodiode, a first capacitor, a second capacitor, and an output amplifier, a cathode of the photodiode, one end of the first capacitor, one end of the second capacitor, and an input of the output amplifier being connected with one another via a first node, an electrode at the other end of the second capacitor being provided on a substrate having a display surface of a display panel, an electrode at the one end of the second capacitor being positioned to be away from the display surface in a thickness direction of the display panel in such a manner as to face the electrode at the other end of the second capacitor, a first pulse being applied to an anode of the photodiode so as to make the photodiode conductive in a forward direction, while the first pulse is applied, a second pulse being applied to the other end of the first capacitor to change a voltage at the first node so that a reverse biased voltage is applied to the photodiode, and while the second pulse is applied, an output from the output amplifier being obtained.

With the invention, capacitance of the second capacitor changes since application of a pressure to the display surface causes a change of the electrode at the other end of the second capacitor and the distance between the electrode at the one end and the electrode at the other end of the second capacitor changes. Consequently, the second capacitor serves as a detection element of a touch sensor, and the first circuit serves as a touch sensor. Application of the first pulse to the anode of the photodiode makes the photodiode conductive in a forward direction, so that the voltage at the first node is substantially equal to a High level voltage of the first pulse.

In that state, the second pulse is applied to the other end of the first capacitor to change the voltage at the first node so that a reverse biased voltage is applied to the photodiode. At that time, the voltage at the first node is determined depending on a ratio in capacitance of the first capacitor to the second capacitor. Capacitance of the first capacitor is not changed by application of a pressure, but capacitance of the second capacitor is changed. Accordingly, the output voltage changes in accordance with capacitance of the second capacitor. Since the output of the output amplifier is obtained while the second pulse is applied, it is possible to detect whether a pressure is applied to the display surface or not.

The detection of the applied pressure is made while the second pulse is applied. Accordingly, even if light is incident to the photodiode, there is little possibility that leakage in the photodiode in a reverse biased state changes the voltage at the first node. Therefore, it is possible to prevent the incident light from being a noise which changes the voltage at the first node in the pressure detection operation.

Therefore, it is possible to realize a display device including a low-priced, downsized, and highly reliable touch panel function without deteriorating a display function.

In this case, a reverse biased voltage applied to the photodiode while the second pulse is applied is relatively small, so that a difference in internal conductivity due to a difference in intensity of light incident to the photodiode is small. Accordingly, a noise due to incident light in the pressure detection operation is reduced to the minimum, achieving a very high accuracy in detection of an applied pressure.

In order to solve the foregoing problems, a display device of the present invention includes, in a display region, a first circuit including a photodiode, a first capacitor, a second capacitor, and an output amplifier, a cathode of the photodiode, one end of the first capacitor, one end of the second capacitor, and an input of the output amplifier being connected with one another via a first node, an electrode at the other end of the second capacitor being provided on a substrate having a display surface of a display panel, an electrode at the one end of the second capacitor being positioned to be away from the display surface in a thickness direction of the display panel in such a manner as to face the electrode at the other end of the second capacitor, a first pulse being applied to an anode of the photodiode so as to make the photodiode conductive in a forward direction, during a period following a period in which the first pulse is applied, a second pulse being applied to the other end of the first capacitor to change a voltage at the first node so that a reverse biased voltage is applied to the photodiode, and while the second pulse is applied, an output from the output amplifier being obtained.

With the invention, capacitance of the second capacitor changes since application of a pressure to the display surface causes a change of the electrode at the other end of the second capacitor and the distance between the electrode at the one end and the electrode at the other end of the second capacitor changes. Consequently, the second capacitor serves as a detection element of a touch sensor, and the first circuit serves as a touch sensor. Application of the first pulse to the anode of the photodiode makes the photodiode conductive in a forward direction, so that the voltage at the first node is substantially equal to a High level voltage of the first pulse.

In that state, the second pulse is applied to the other end of the first capacitor to change the voltage at the first node so that a reverse biased voltage is applied to the photodiode. At that time, the voltage at the first node is determined depending on a ratio in capacitance of the first capacitor to the second capacitor. Capacitance of the first capacitor is not changed by application of a pressure, but capacitance of the second capacitor is changed. Accordingly, the output voltage changes in accordance with capacitance of the second capacitor. Since the output of the output amplifier is obtained while the second pulse is applied, it is possible to detect whether a pressure is applied to the display surface or not.

The detection of the applied pressure is made while the second pulse is applied. Accordingly, even if light is incident to the photodiode, there is little possibility that leakage in the photodiode in a reverse biased state changes the voltage at the first node. Therefore, it is possible to prevent the incident light from being a noise which changes the voltage at the first node in the pressure detection operation.

Therefore, it is possible to realize a display device including a low-priced, downsized, and highly reliable touch panel function without deteriorating a display function.

Further, it is possible to easily set timing of applying the second pulse by using end timing of the first pulse.

Further, since it is possible to shorten the period of the first pulse, a noise caused by light incident to the photodiode conductive in a forward direction during the period of the first pulse can be reduced to the minimum. Therefore, it is possible to further improve accuracy in detecting an applied pressure.

In order to solve the foregoing problems, a method of the present invention is a method for driving a display device including, in a display region, a first circuit including a photodiode, a first capacitor, a second capacitor, and an output amplifier, a cathode of the photodiode, one end of the first capacitor, one end of the second capacitor, and an input of the output amplifier being connected with one another via a first node, an electrode at the other end of the second capacitor being provided on a substrate having a display surface of a display panel, an electrode at the one end of the second capacitor being positioned to be away from the display surface in a thickness direction of the display panel in such a manner as to face the electrode at the other end of the second capacitor, the method comprising causing the first circuit to carry out a first operation of (i) applying a first direct voltage to an anode of the photodiode so that application of the first direct voltage to the anode during a first period makes the photodiode conductive in a forward direction, (ii) while the first direct voltage is applied to the anode during a second period following the first period, applying a second pulse to the other end of the first capacitor to change a voltage at the first node so that a reverse biased voltage is applied to the photodiode, and (iii) while the second pulse is applied, obtaining an output from the output amplifier.

With the invention, the first direct voltage is applied to the anode of the photodiode. During the first period, the application of the first direct voltage makes the photodiode conductive in a forward direction, so that the voltage at the first node is substantially equal to the first direct voltage.

During the second period, while the first direct voltage is applied to the anode, the second pulse is applied to the other end of the first capacitor to change the voltage at the first node so that a reverse biased voltage is applied to the photodiode. At that time, the voltage at the first node is determined depending on a ratio in capacitance of the first capacitor to the second capacitor. Capacitance of the first capacitor is not changed by application of a pressure, but capacitance of the second capacitor is changed. Accordingly, the output voltage changes in accordance with capacitance of the second capacitor. Since the output of the output amplifier is obtained while the second pulse is applied, it is possible to detect whether a pressure is applied to the display surface or not.

The detection of the applied pressure is made while the second pulse is applied. Accordingly, even if light is incident to the photodiode, there is little possibility that leakage in the photodiode in a reverse biased state changes the voltage at the first node. Therefore, it is possible to prevent the incident light from being a noise which changes the voltage at the first node in the pressure detection operation.

Therefore, it is possible to realize a display device including a low-priced, downsized, and highly reliable touch panel function without deteriorating a display function. Further, since the first direct voltage is not a pulse but a DC voltage, it is unnecessary to determine timing. Thus, setting of timing is further easier.

In order to solve the foregoing problems, a method of the present invention is a method for driving a display device including, in a display region, a first circuit including a photodiode, a first capacitor, a second capacitor, and an output amplifier, a cathode of the photodiode, one end of the first capacitor, one end of the second capacitor, and an input of the output amplifier being connected with one another via a first node, an electrode at the other end of the second capacitor being provided on a substrate having a display surface of a display panel, an electrode at the one end of the second capacitor being positioned to be away from the display surface in a thickness direction of the display panel in such a manner as to face the electrode at the other end of the second capacitor, the method comprising causing the first circuit to carry out a first operation of (i) applying a first pulse to an anode of the photodiode so as to make the photodiode conductive in a forward direction, (ii) while the first pulse is applied, applying a second pulse to the other end of the first capacitor to change a voltage at the first node so that a reverse biased voltage is applied to the photodiode, and (iii) while the second pulse is applied, obtaining an output from the output amplifier.

With the invention, application of the first pulse to the anode of the photodiode makes the photodiode conductive in a forward direction, so that the voltage at the first node is substantially equal to a High level voltage of the first pulse. In that state, the second pulse is applied to the other end of the first capacitor to change the voltage at the first node so that a reverse biased voltage is applied to the photodiode. At that time, the voltage at the first node is determined depending on a ratio in capacitance of the first capacitor to the second capacitor. Capacitance of the first capacitor is not changed by application of a pressure, but capacitance of the second capacitor is changed. Accordingly, the output voltage changes in accordance with capacitance of the second capacitor. Since the output of the output amplifier is obtained while the second pulse is applied, it is possible to detect whether a pressure is applied to the display surface or not.

The detection of the applied pressure is made while the second pulse is applied. Accordingly, even if light is incident to the photodiode, there is little possibility that leakage in the photodiode in a reverse biased state changes the voltage at the first node. Therefore, it is possible to prevent the incident light from being a noise which changes the voltage at the first node in the pressure detection operation.

Therefore, it is possible to realize a display device including a low-priced, downsized, and highly reliable touch panel function without deteriorating a display function.

In order to solve the foregoing problems, a method of the present invention is a method for driving a display device including, in a display region, a first circuit including a photodiode, a first capacitor, a second capacitor, and an output amplifier, a cathode of the photodiode, one end of the first capacitor, one end of the second capacitor, and an input of the output amplifier being connected with one another via a first node, an electrode at the other end of the second capacitor being provided on a substrate having a display surface of a display panel, an electrode at the one end of the second capacitor being positioned to be away from the display surface in a thickness direction of the display panel in such a manner as to face the electrode at the other end of the second capacitor, the method comprising causing the first circuit to carry out a first operation of (i) applying a first pulse to an anode of the photodiode so as to make the photodiode conductive in a forward direction, (ii) during a period following a period in which the first pulse is applied, applying a second pulse to the other end of the first capacitor to change a voltage at the first node so that a reverse biased voltage is applied to the photodiode, and (iii) while the second pulse is applied, obtaining an output from the output amplifier.

With the invention, application of the first pulse to the anode of the photodiode makes the photodiode conductive in a forward direction, so that the voltage at the first node is substantially equal to a High level voltage of the first pulse. In that state, the second pulse is applied to the other end of the first capacitor to change the voltage at the first node so that a reverse biased voltage is applied to the photodiode. At that time, the voltage at the first node is determined depending on a ratio in capacitance of the first capacitor to the second capacitor. Capacitance of the first capacitor is not changed by application of a pressure, but capacitance of the second capacitor is changed. Accordingly, the output voltage changes in accordance with capacitance of the second capacitor. Since the output of the output amplifier is obtained while the second pulse is applied, it is possible to detect whether a pressure is applied to the display surface or not.

The detection of the applied pressure is made while the second pulse is applied. Accordingly, even if light is incident to the photodiode, there is little possibility that leakage in the photodiode in a reverse biased state changes the voltage at the first node. Therefore, it is possible to prevent the incident light from being a noise which changes the voltage at the first node in the pressure detection operation.

Therefore, it is possible to realize a display device including a low-priced, downsized, and highly reliable touch panel function without deteriorating a display function.

Further, it is possible to easily set timing of applying the second pulse by using end timing of the first pulse.

Further, since it is possible to shorten the period of the first pulse, a noise caused by light incident to the photodiode conductive in a forward direction during the period of the first pulse can be reduced to the minimum. Therefore, it is possible to further improve accuracy in detecting an applied pressure.

Advantageous Effects of Invention

As described above, the display device of the present invention includes, in a display region, a first circuit including a photodiode, a first capacitor, a second capacitor, and an output amplifier, a cathode of the photodiode, one end of the first capacitor, one end of the second capacitor, and an input of the output amplifier being connected with one another via a first node, an electrode at the other end of the second capacitor being provided on a substrate having a display surface of a display panel, and an electrode at the one end of the second capacitor being positioned to be away from the display surface in a thickness direction of the display panel in such a manner as to face the electrode at the other end of the second capacitor.

Therefore, it is possible to realize a display device including a low-priced, downsized, and highly reliable touch panel function without deteriorating a display function.

Brief Description of Drawings

Fig. 1

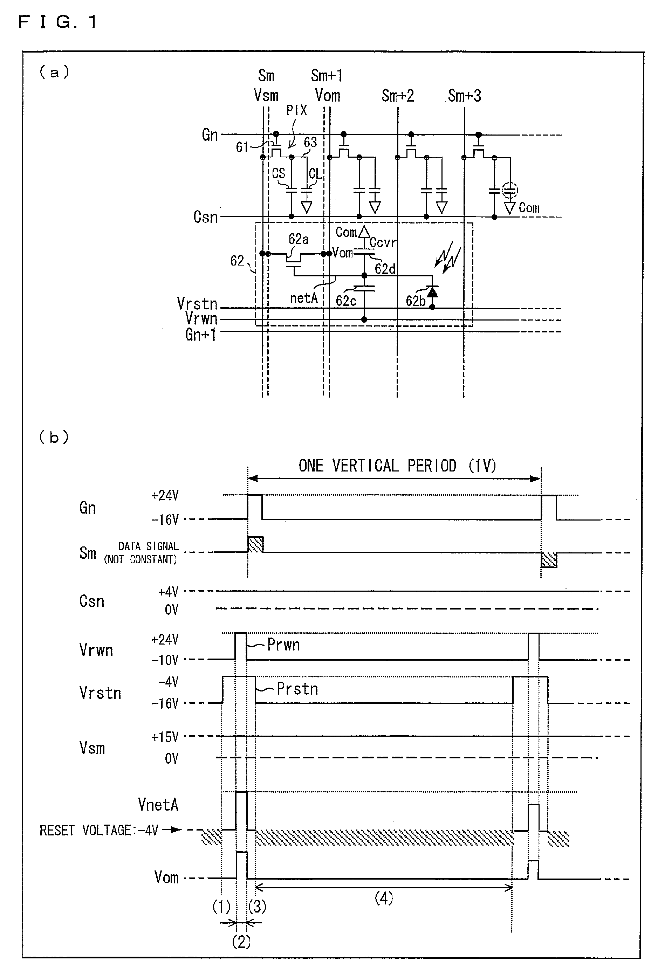

Fig. 1 is a drawing showing a structure and an operation of a display region in accordance with an embodiment of the present invention. (a) of Fig. 1 is a circuit diagram showing the structure of the display region. (b) is a waveform chart showing the operation of the display region.
Fig. 2

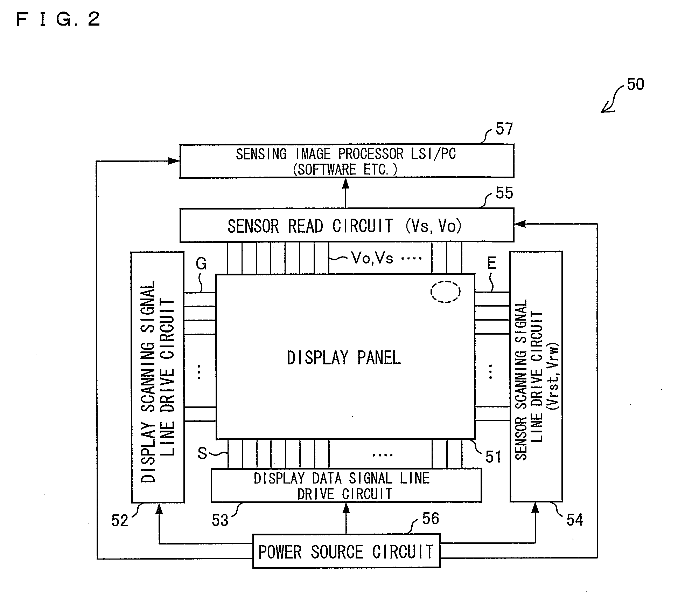

Fig. 2 is a block diagram showing a structure of a display device including the display region shown in Fig. 1.
Fig. 3

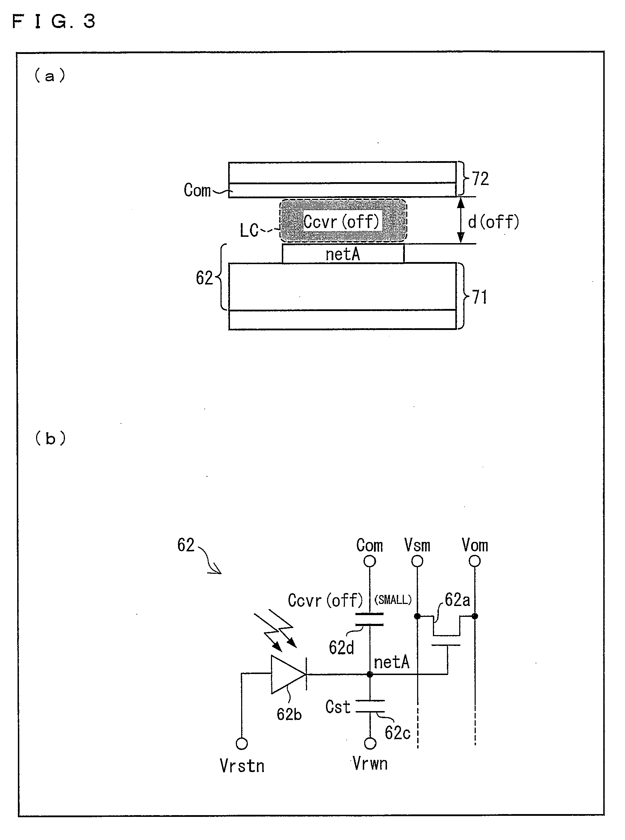

Fig. 3 is a drawing showing a cross section of a sensor circuit region where no pressure is applied and the sensor circuit in the display region shown in Fig. 1. (a) of Fig. 3 is a cross sectional view showing the sensor circuit region where no pressure is applied in the display region shown in Fig. 1. (b) of Fig. 3 is a circuit diagram showing the sensor circuit shown in (a) of Fig. 3.
Fig. 4

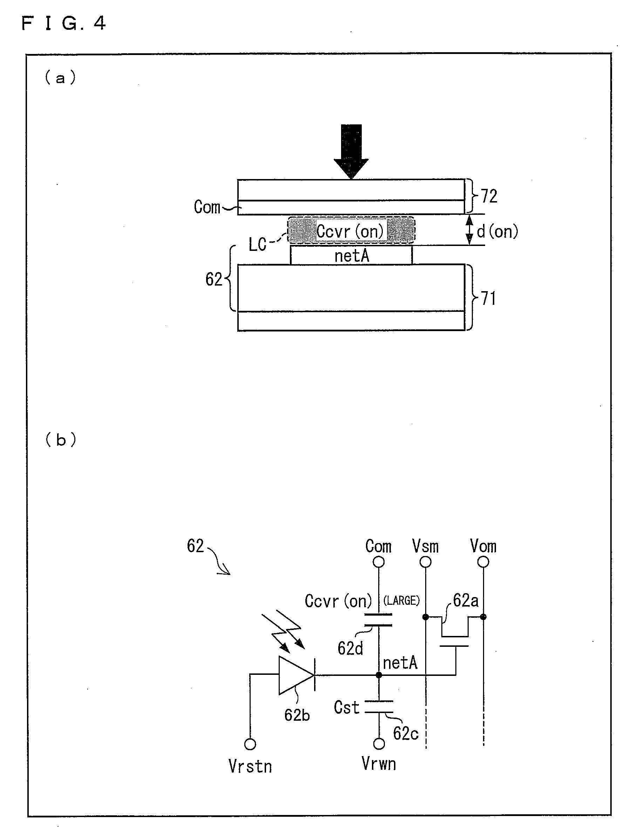

Fig. 4 is a drawing showing a cross section of a sensor circuit region where a pressure is applied and the sensor circuit in the display region shown in Fig. 1. (a) of Fig. 4 is a cross sectional view showing the sensor circuit region where a pressure is applied in the display region shown in Fig. 1. (b) of Fig. 4 is a circuit diagram showing the sensor circuit shown in (a) of Fig. 4.
Fig. 5

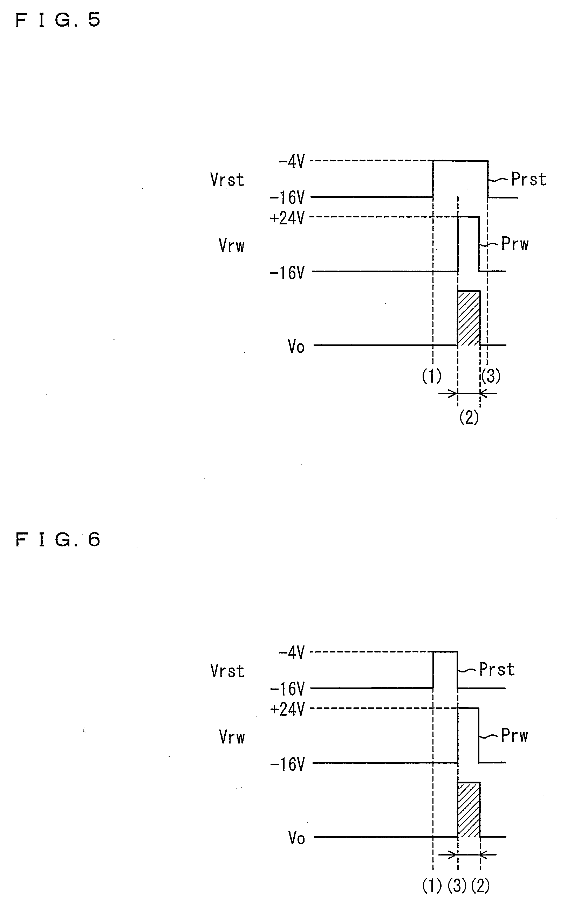

Fig. 5 is a waveform chart showing a first operation of a sensor circuit in accordance with the embodiment of the present invention.
Fig. 6
Fig. 6 is a waveform chart showing a second operation of a sensor circuit in accordance with the embodiment of the present invention.
Fig. 7

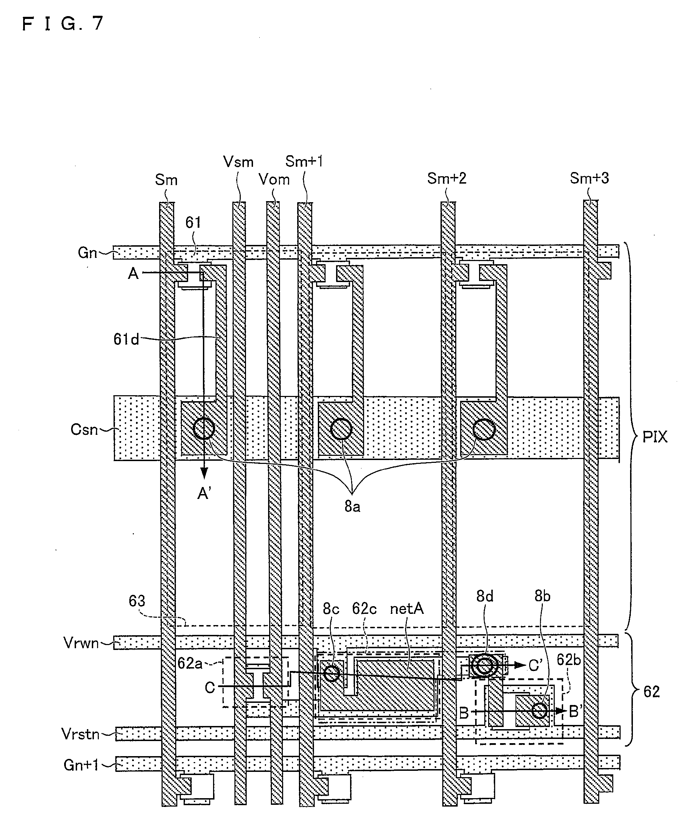

Fig. 7 is a plan view showing a first pattern positioning example of a display region in accordance with the embodiment of the present invention.
Fig. 8

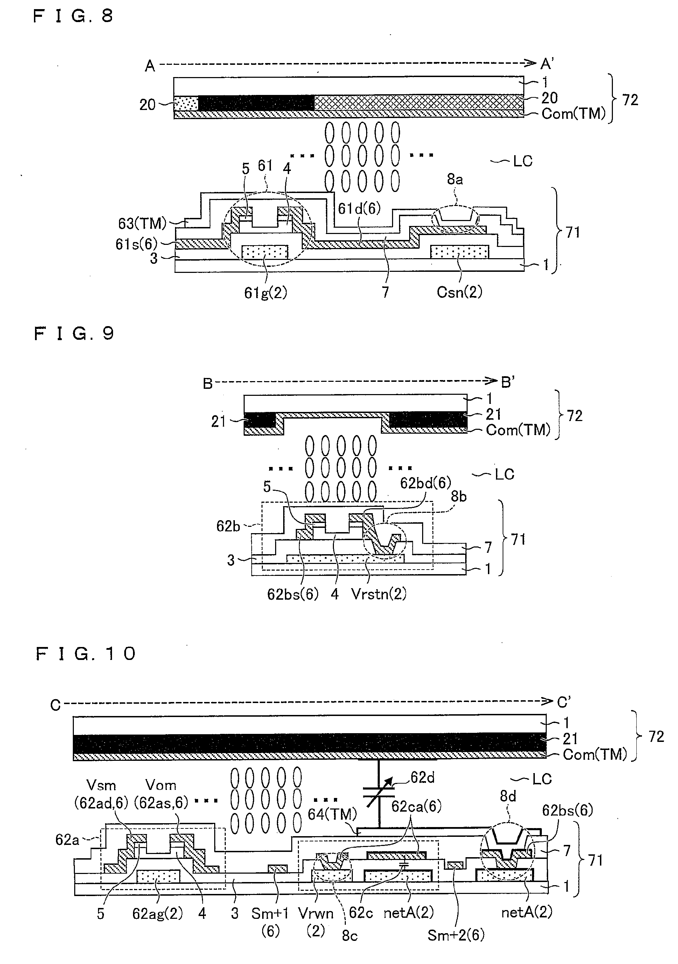

Fig. 8 is a cross sectional view taken along a line A-A' of Fig. 7.
Fig. 9
Fig. 9 is a cross sectional view taken along a line B-B' of Fig. 7.
Fig. 10
Fig. 10 is a cross sectional view taken along a line C-C' of Fig. 7.
Fig. 11

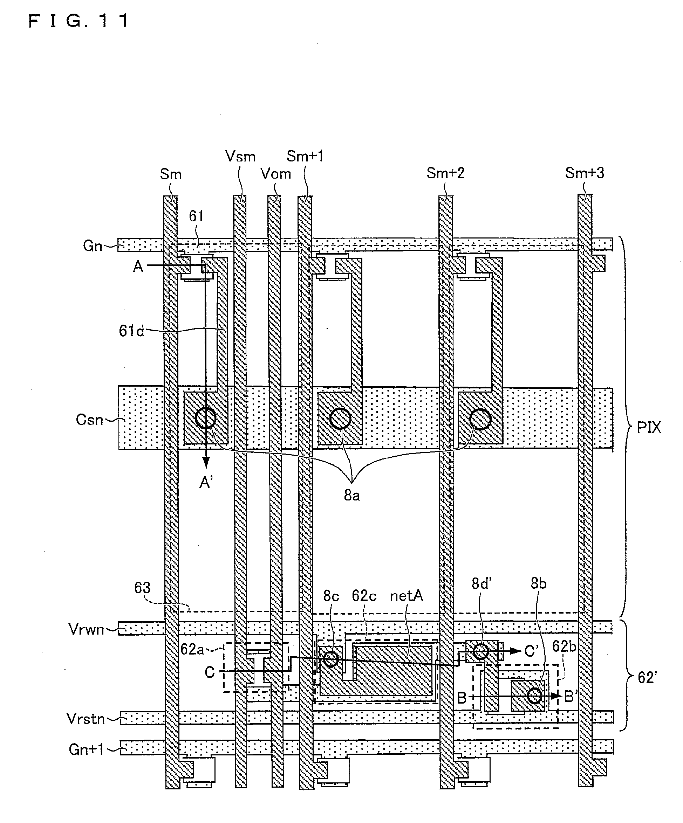

Fig. 11 is a plan view showing a second pattern positioning example of a display region in accordance with the embodiment of the present invention.
Fig. 12

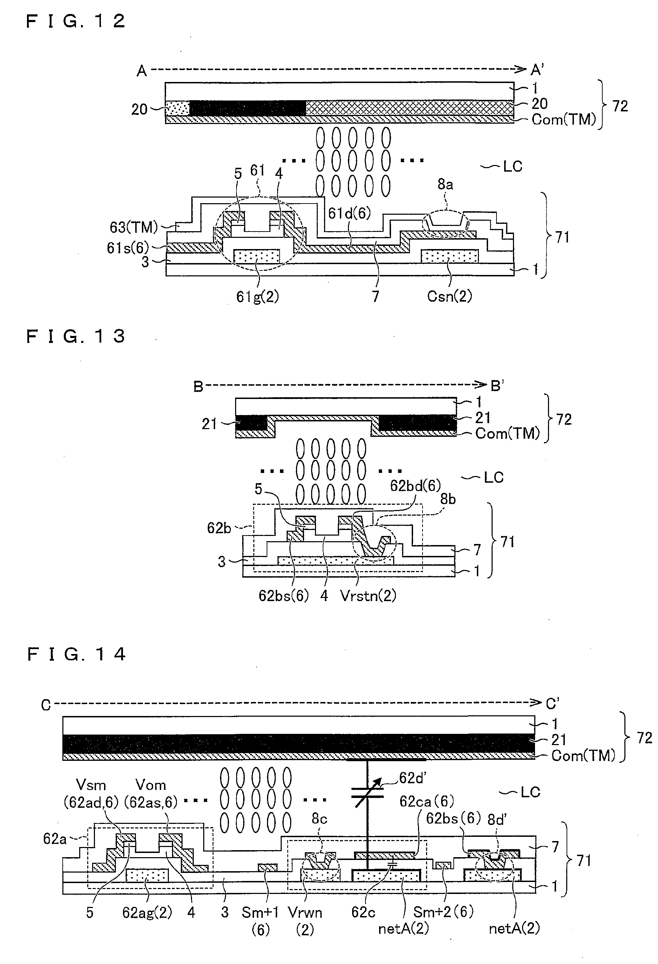

Fig. 12 is a cross sectional view taken along a line A-A' of Fig. 11.
Fig. 13

Fig. 13 is a cross sectional view taken along a line B-B' of Fig. 11.

Fig. 14

Fig. 14 is a cross sectional view taken along a line C-C' of Fig. 11.

Fig. 15

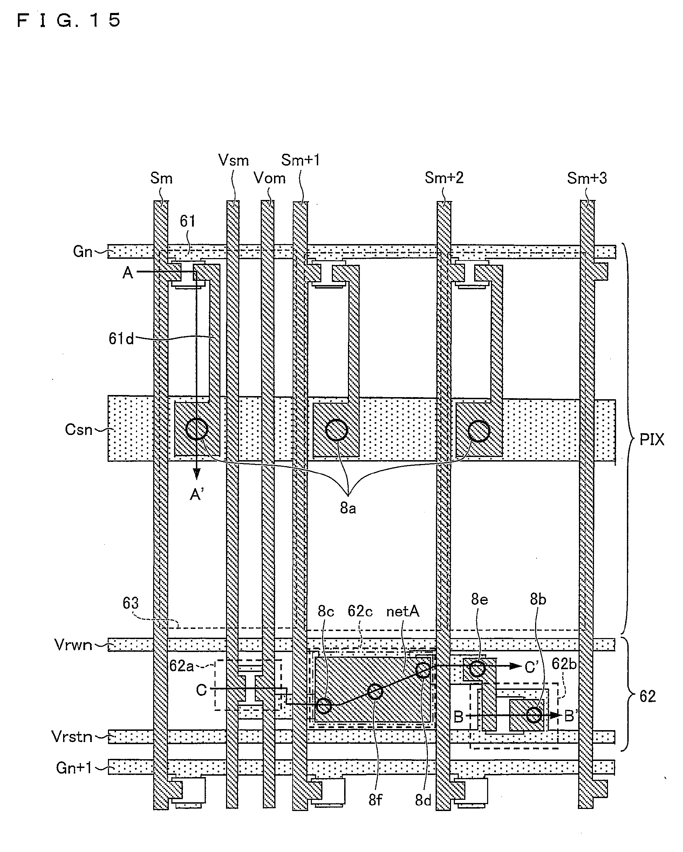

Fig. 15 is a plan view showing a third pattern positioning example of a display region in accordance with the embodiment of the present invention.

Fig. 16

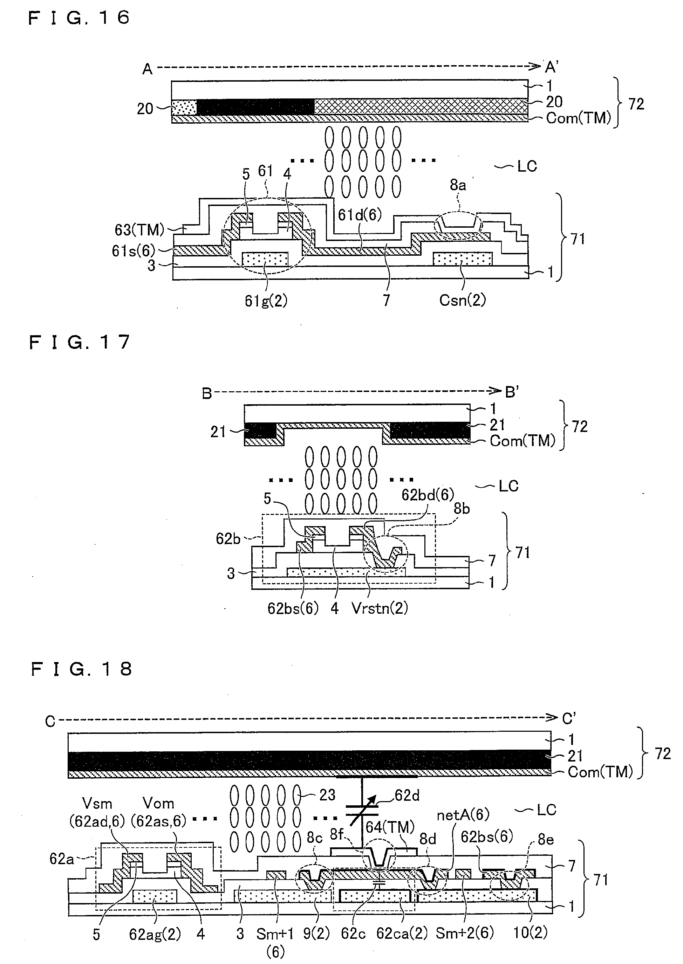

Fig. 16 is a cross sectional view taken along a line A-A' of Fig. 15.

Fig. 17

Fig. 17 is a cross sectional view taken along a line B-B' of Fig. 15.

Fig. 18

Fig. 18 is a cross sectional view taken along a line C-C' of Fig. 15.

Fig. 19

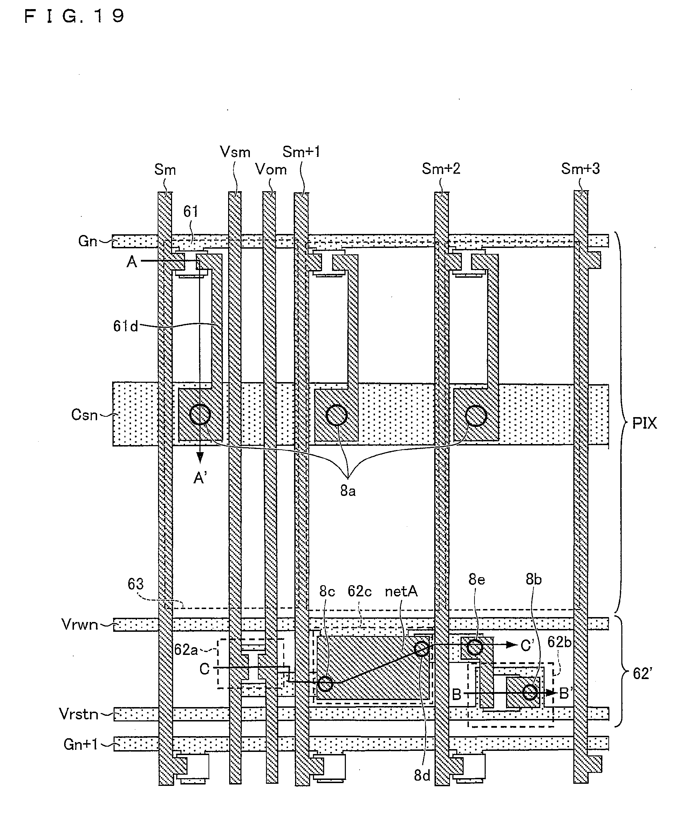

Fig. 19 is a plan view showing a fourth pattern positioning example of a display region in accordance with the embodiment of the present invention.

Fig. 20

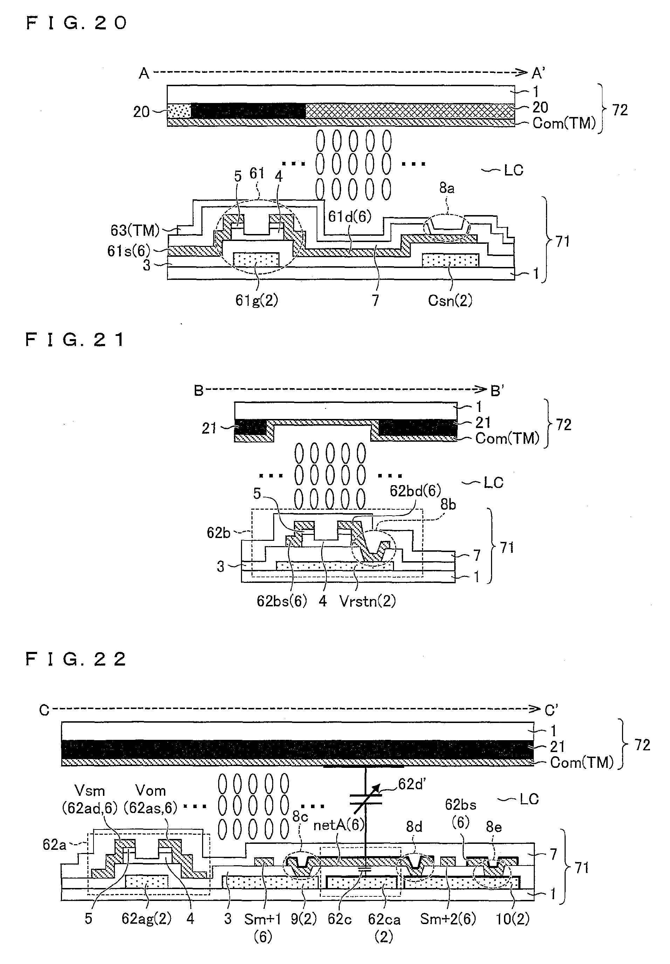

Fig. 20 is a cross sectional view taken along a line A-A' of Fig. 19.

Fig. 21

Fig. 21 is a cross sectional view taken along a line B-B' of Fig. 19.

Fig. 22

Fig. 22 is a cross sectional view taken along a line C-C' of Fig. 19.

Fig. 23

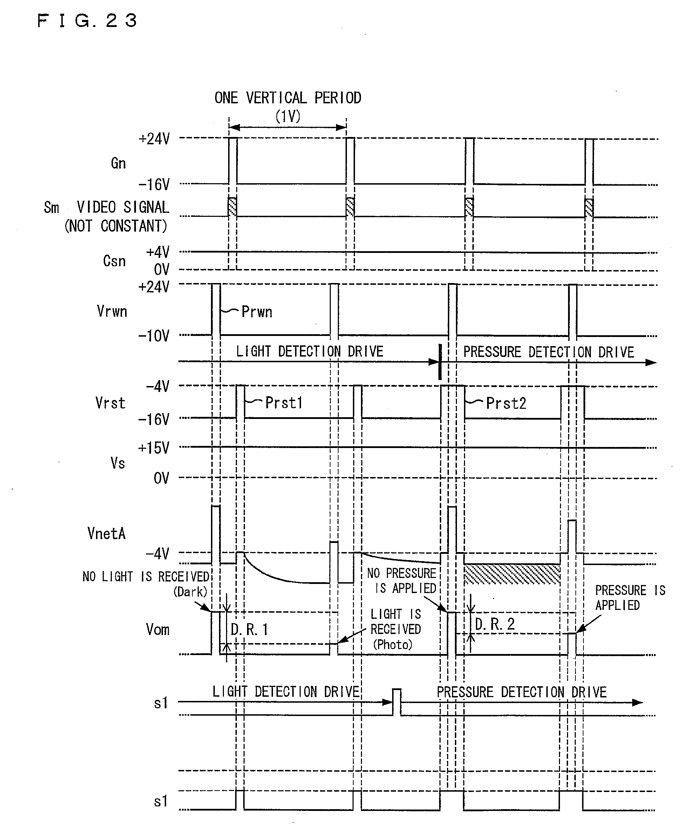

Fig. 23 is a signal waveform chart showing a method for driving a display device of a first Example in accordance with the embodiment of the present invention.

Fig. 24

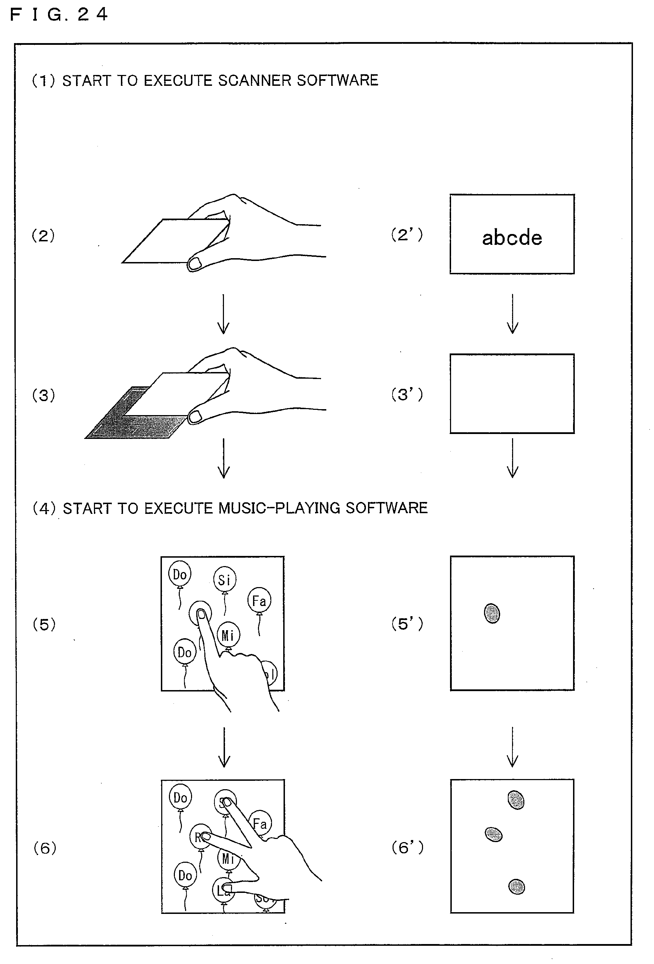

Fig. 24 is a drawing showing a method for using a display device driven according to the method shown in Fig. 23.

Fig. 25

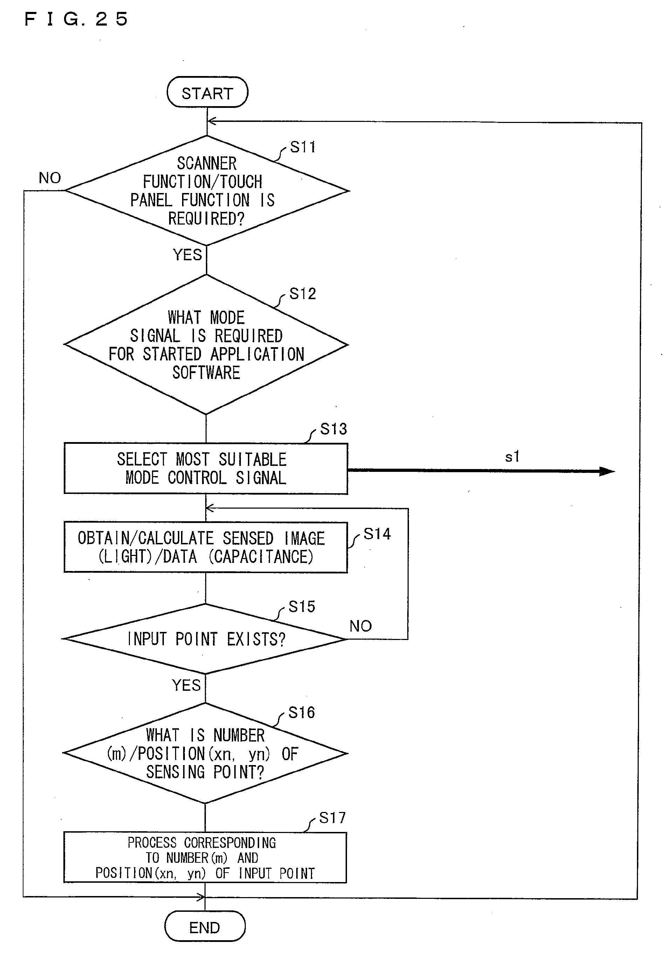

Fig. 25 is a flowchart showing a method for driving the display device shown in Figs. 23 and 24.

Fig. 26

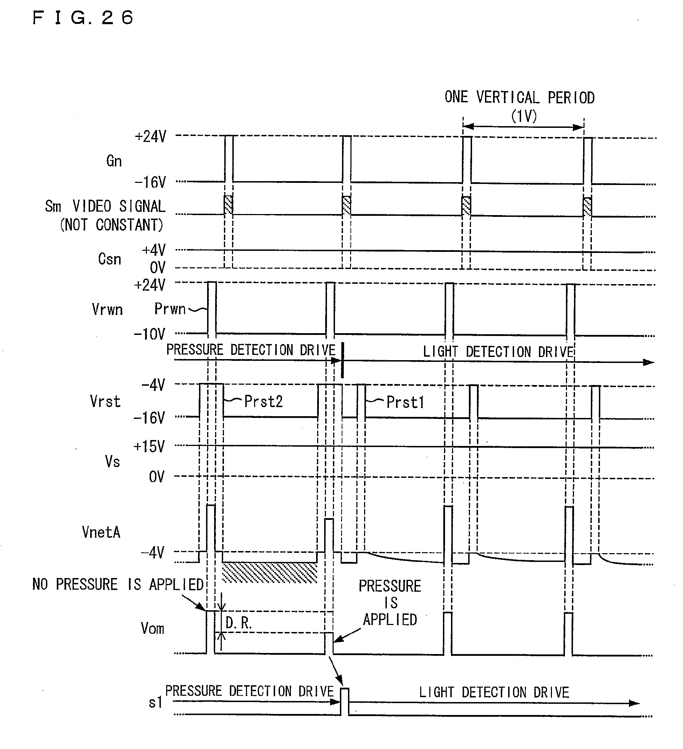

Fig. 26 is a signal waveform chart showing a method for driving a display device of a second Example in accordance with the embodiment of the present invention.

Fig. 27

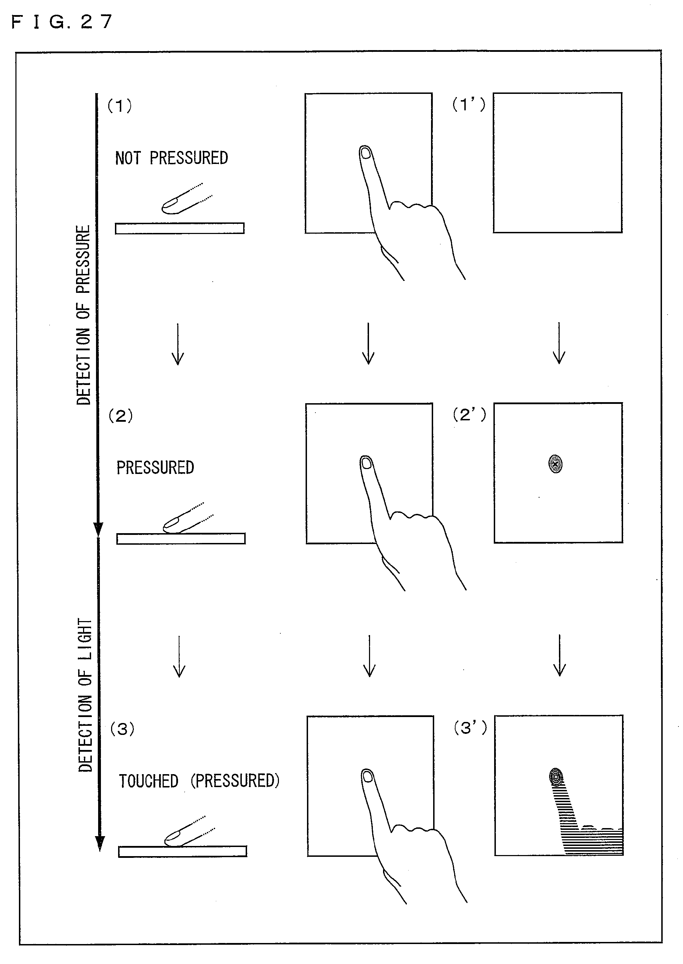

Fig. 27 is a drawing showing a method for using a display device driven according to the method shown in Fig. 26.

Fig. 28

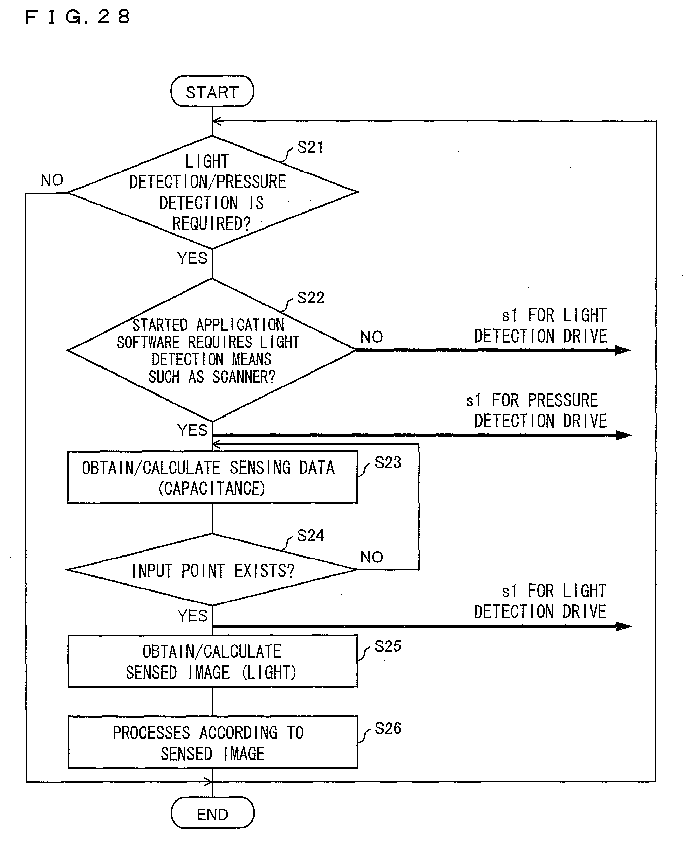

Fig. 28 is a flowchart showing a method for driving the display device shown in Figs. 26 and 27.

Fig. 29

Fig. 29 is a circuit diagram showing a structure of a display region in a conventional art.

Fig. 30

Fig. 30 is a waveform chart showing an operation of the display region shown in Fig. 29.

Description of Embodiments

The following explains an embodiment of the present invention with reference to Figs. 1-28.

Fig. 2 shows a configuration of a liquid crystal display device (display device) 50 in accordance with the present Embodiment.

The liquid crystal display device 50 is an active matrix display device including a display panel 51, a display scanning signal line drive circuit 52, a display data signal line drive circuit 53, a sensor scanning signal line drive circuit 54, a sensor read circuit 55, a power source circuit 56, and a sensing image processor 57.

The display panel 51 includes a plurality of gate lines G and a plurality of source lines S crossing the plurality of gate lines G, and a display region where picture elements PIX are positioned in a matrix manner so as to respectively correspond to intersections of the plurality of gate lines G and the plurality of source lines S.

The display scanning signal line drive circuit 52 drives the gate lines G by sequentially outputting, to the gate lines G, scanning signals for selecting picture elements PIX into which data signals are to be written. The display data signal line drive circuit 53 drives the source lines S by outputting data signals to the source lines S. The sensor scanning signal line drive circuit (drive circuit of first circuit) 54 line-sequentially drives sensor scanning signal lines E by sequentially outputting, to the sensor scanning signal lines E, scanning signals (voltage Vrst, voltage Vrw) for causing sensor circuits to operate. The sensor read circuit 55 reads, from sensor output lines Vo, sensor output voltages Vo (for convenience of explanation, the sensor output lines and the sensor output voltages are given the same reference sign), and supplies power source voltages to sensor power source lines Vs. The power source circuit 56 supplies power sources required for operations of the display scanning signal line drive circuit 52, the display data signal line drive circuit 53, the sensor scanning signal line drive circuit 54, the sensor read circuit 55, and the sensing image processor 57. The sensing image processor 57 analyzes distribution of the results of detections by sensors in a panel plane, based on the sensor output voltages Vo read by the sensor read circuit 55.

The functions of the sensor scanning signal line drive circuit 54 and the sensor read circuit 55 may be included in other circuits such as the display scanning signal line drive circuit 52 and the display data signal line drive circuit 53. Further, the function of the sensor read circuit 55 may be included in the sensing image processor 57. Further, the sensing image processor 57 may be provided in the liquid crystal display device 50 in such a manner that the sensing image processor 57 is an LSI, a part of a computer etc. Alternatively, the sensing image processor 57 may be provided outside the liquid crystal display device 50. Similarly, the sensor read circuit 55 may be provided outside the liquid crystal display device 50.

Next, (a) of Fig. 1 shows a detailed configuration of the display region.

(a) of Fig. 1 shows a configuration of an n-th row in the display region. The configuration of the n-th row includes a gate line Gn, source lines S (in the drawing, Sm to Sm+3 are shown), a plurality of picture elements PIX comparted by a retention capacitor line Csn, and at least one sensor circuit 62 connected with a reset line Vrstn and a read control line Vrwn which are two kinds of sensor scanning signal lines E. "n" and "m" at the end of a sign indicate a row number and a column number, respectively. The retention capacitor line Csn, the reset line Vrstn, and the read control line Vrwn are positioned to be parallel to the gate line Gn.

Each picture element PIX includes a TFT 61 serving as a selection element, a liquid crystal capacitor CL, and a retention capacitor CS. A gate of the TFT 61 is connected with the gate line Gn, a source of the TFT 61 is connected with the source line S, and a drain of the TFT 61 is connected with a picture element electrode 63. The liquid crystal capacitor CL is a capacitor formed by positioning a liquid crystal layer between the picture element electrode 63 and a common electrode Com. The retention capacitor CS is a capacitor formed by positioning an insulating film between the picture element electrode 63 or the drain electrode of the TFT 61 and the retention capacitor line Csn. Constant voltages for example are applied to the common electrode Com and the retention capacitor line Csn.

The sensor circuit (first circuit) 62 is provided in any number. For example, the sensor circuit 62 is provided with respect to one picture element PIX or one pixel (e.g. a set of picture elements PIX corresponding to R, G, B, respectively). The sensor circuit 62 includes a TFT 62a, a photodiode 62b, and capacitors 62c and 62d. A gate (input of output amplifier) of the TFT (output amplifier) 62a is connected with an electrode called a node (first node) netA, a drain of the TFT 62a is connected with one source line S (here, Sm), and a source (output of output amplifier) of the TFT 62a is connected with another one source line S (here, Sm+1). An anode of the photodiode (light-receiving element) 62b is connected with the reset line Vrstn and a cathode of the photodiode 62b is connected with the node netA. One end of the capacitor (first capacitor) 62c is connected with the node netA and the other end of the capacitor 62c is connected with the read control line Vrwn, so that a capacitor is formed between the node netA and the read control line Vrwn with a gate insulating film therebetween. One end of the capacitor (second capacitor) 62d is connected with the node netA and the other end of the capacitor 62d is connected with the common electrode Com, so that a capacitor with capacitance Ccvr is formed between the node netA and the common electrode Com with a liquid crystal layer therebetween.

The sensor circuit 62 carries out two operations (operation in a light detection mode and operation in a pressure detection mode). Thus, the sensor circuit 62 serves not only an optical sensor circuit but also as a touch sensor circuit.

In the light detection mode, during a period other than a period in which data signals are written into picture elements PIX, a voltage appearing at the node netA in accordance with intensity of light incident to the photodiode 62b is outputted as a sensor output voltage Vom from the source of the TFT 62a to the sensor read circuit 55 outside the display region via the source line S (serving as a sensor output line Vom when detecting light) connected with the source of the TFT 62a. At that time, the TFT 62a serves as a source follower, and the sensor output line Vom gets electrically disconnected from the output of the display data signal line drive circuit 53. The source line S connected with the drain of the TFT 62a gets electrically disconnected from the output of the display data signal line drive circuit 53 when light is detected, and the source line S serves as a power source line Vsm to which a constant voltage is applied from the sensor read circuit 55. Alternatively, the sensor output line Vom and the power source line Vsm may be provided independently of the source lines S as shown by broken lines close to the source lines S. The operation in the light detection mode is similar to the operation explained with reference to Fig. 30, and explained again below with reference to Fig. 30.

When a reset pulse (third pulse) Prstn is applied to the anode of the photodiode 62b, the photodiode 62b gets conductive in a forward direction, and the voltage at the node netA is determined by the voltage of the reset pulse Prstn and capacitances of the capacitors 62c and 62d. When a period in which the reset pulse Prstn is applied ends, a reverse biased voltage is applied to the photodiode 62b. After a predetermined period (2), the voltage at the node netA corresponds to leakage in accordance with intensity of light incident to the photodiode 62b. In this state, a read pulse (fourth pulse) Prwn is applied to the other end of the capacitor 62c, and a voltage VnetA is changed to be capable of being outputted from the source of the TFT 62a. Then, while the read pulse Prwn is applied, the output of the TFT 62a is obtained. Thus, intensity of light incident to the photodiode 62b can be detected.

The following explains the operation in the pressure detection mode.

Since the sensor circuit 62 includes the capacitor 62d, the distance between the other end of the capacitor 62d (i.e. the common electrode Com positioned oppositely to the node netA) and one end of the capacitor 62d (i.e. the electrode at the node netA) changes in accordance with a change in a panel thickness direction which is caused by pressure applied to a display surface of a display panel by a user. Accordingly, the sensor circuit 62 can detect the pressure applied to the display surface by detecting a change in capacitance Ccvr of the capacitor 62d due to this change. Therefore, the sensor circuit 62 serves as a touch sensor.

Detailed plane view and detailed cross sectional view of the picture element PIX and the sensor circuit 62 are explained later. Here, an explanation is made as to the operation in the pressure detection mode with reference to schematic cross sectional views of Figs. 3 and 4.

(a) of Fig. 3 is a cross sectional view of a panel when no pressure is applied to a panel surface. The panel is designed such that a liquid crystal layer LC is provided between a TFT substrate (matrix substrate) 71 and a counter substrate (substrate having display surface) 72, and a capacitor 62d is formed between the node netA on the upper plane of the TFT substrate and the common electrode Com. In this state, since the counter substrate 72 is not pressed, the common electrode Com does not change and a distance d (off) between the node netA and the common electrode Com is large. Accordingly, capacitance Ccvr (off) of the capacitor 62d is small. Consequently, as shown in (b) of Fig. 3, the voltage at the node netA is based on charge sharing by the capacitor 62c having constant capacitance Cst and the capacitor 62d having small capacitance Ccvr (off).

(a) of Fig. 4 shows a cross sectional view of the panel when a pressure is applied to the panel surface. In this state, since the counter substrate 72 is pressed, the common electrode Com changes and a distance d (on) between the node netA and the common electrode Com is small. Accordingly, capacitance Ccvr (on) of the capacitor 62d is large. Consequently, as shown in (b) of Fig. 4, the voltage at the node netA is based on charge sharing by the capacitor 62c having constant capacitance Cst and the capacitor 62d having large capacitance Ccvr (on).

The voltage VnetA at the node netA is represented by

$$\mathrm{VnetA = Vinit + (Cst/Ctotal) \times \Delta Vrw}$$

wherein Vinit indicates a reset voltage for the node netA before detecting application of a pressure, Ctotal indicates whole capacitances of capacitors connected with the node netA, and $\Delta$Vrw indicates a stepwise change in voltage applied to the read control line Vrwn.

Here, Ctotal includes capacitances of Cst, Ccvr, and other parasitic capacitors.

The sensor output voltage Vom represented by the source voltage of the TFT 62a is larger as the voltage VnetA is larger. Accordingly, the sensor output voltage Vom is larger as $\alpha$ = Cst/Ctotal is larger, i.e. as Ctotal is smaller. Since Ccvr (off) < Ccvr (on), the sensor output voltage Vom is smaller when a pressure is applied than when no pressure is applied. Therefore, by the sensor read circuit 55 reading out the sensor output voltage Vom and determining whether the sensor output voltage Vom is larger or smaller, it is possible to distinguish whether a pressure is applied or not.

With reference to (b) of Fig. 1, the following details the operation of the sensor circuit 62 in the pressure detection mode. In the present embodiment, when the operation in the pressure detection mode is carried out, the light detection operation is stopped, and when the operation in the light detection mode is carried out, the pressure detection mode is stopped.

During a writing period in which a data signal is written, a gate pulse consisting of +24V High level and -16V Low level is outputted as a scanning signal to the gate line Gn, and data signals are outputted to the source lines S. A constant voltage (e.g. +4V) is applied to the retention capacitor line Csn. This operation is repeated with respect to picture elements PIX in each row per one vertical period (1V). Other than the writing period, the result Vom of pressure detection by the sensor circuit 62 can be outputted to the sensor read circuit 55.

At a time (1), when a reset pulse (first pulse) Prstn consisting of -4V High level and -16V Low level for example is applied from the sensor scanning signal line drive circuit 54 to the reset line Vrstn, the photodiode 62b gets conductive in a forward direction, and the voltage VnetA at the node netA is reset. At that time, the voltage Vnet is substantially reset to a High level voltage of the reset pulse Prstn. Thereafter, during a period (2) in which the reset pulse Prstn is applied, a read pulse (second pulse) Prwn consisting of +24V High level and -10V Low level is applied from the sensor scanning signal line drive circuit 54 to the read control line Vrwn, so that the voltage VnetA at the node netA increases. At that time, the voltage VnetA is set so that a voltage between the gate and the source of the TFT 62a goes beyond a threshold voltage. Application of the read pulse Prwn puts the voltage VnetA in a state where a reverse biased voltage is applied to the photodiode 62b and in a state where the output from the source of the TFT 62a is possible.

The sensor output voltage Vom outputted from the source of the TFT 62a while the read pulse Prwn is applied corresponds to the voltage VnetA, i.e. corresponds to the degree of the applied pressure. Therefore, by the sensor read circuit 55 reading the sensor output voltage Vom via the sensor output line Vom and comparing the sensor output voltage Vom with a threshold value to determine whether the sensor output voltage Vom is larger or smaller than the threshold value, it is possible to determine whether a pressure is applied or not. When the reset pulse Prstn falls at a time (3) after falling of the read pulse Prwn, the sensor circuit 62 stops its operation during a period (4) before the next reset operation.

During the period (4), the photodiode 62b which has been put in a revere biased state due to fall of the reset pulse Prstn suffers leakage according to intensity of light incident to the photodiode 62b. Accordingly, the voltage VnetA changes in accordance with the light intensity. However, since detection of application of a pressure is carried out during the period (2), it is possible to prevent incident light from being a noise which changes the voltage VnetA in the pressure detection operation.

In the above example, as shown in Fig. 5, a period of the read pulse Prw, i.e. a period in which the sensor read circuit 55 reads out the sensor output voltage Vo, is set to be within a period of the reset pulse Prst. In this case, a reverse biased voltage applied to the photodiode 62b during the period (2) is relatively small, so that a difference in internal conductivity due to a difference in intensity of light incident to the photodiode 62 is small. Accordingly, a noise due to incident light in the pressure detection operation is reduced to the minimum, achieving a very high accuracy in detection of an applied pressure.

However, the present invention is not limited to the above. Alternatively, as shown in Fig. 6, the period of the read pulse Prw, i.e. a period in which the sensor read circuit 55 reads out the sensor output voltage Vo is set to follow the reset pulse Prst. The timing of Fig. 6 may be understood as, in Fig. 5, the period (2) of the read pulse Prw starting at the time (3) at which the reset pulse Prst whose pulse period ranges from the time (1) to the time (3) falls. Also in the configuration of Fig. 6, the sensor output voltage Vo is read out right after the voltage Vnet is reset. Accordingly, even if light with any intensity is incident to the photodiode 62b, the node netA does not go through a floating state where the voltage VnetA is susceptible to a change in voltage before reading the sensor output voltage Vo. Accordingly, it is possible to prevent incident light from being a noise which changes the voltage VnetA in the pressure detection operation.

According to the process shown in Fig. 6, the fall timing of the reset pulse Prw is equal to the rise timing of the read pulse Prw, and so timing setting is easy. Further, since detection of an applied pressure is made right after resetting, a noise due to incident light is not problematic. Besides, since the period of the reset pulse Prw can be shorter, a noise due to light incident to the photodiode 62b in a forwardly conductive state during a reset period can be reduced to the minimum. This enables further increasing accuracy in detection of an applied pressure.

In the examples in Figs. 5 and 6, application of a voltage to the reset line Vrst is made by a pulse. Alternatively, the application of a voltage to the reset line Vrst may be made by a DC voltage (first direct current voltage). A specific example thereof is a DC voltage of -4V. Specific arrangement is as follows: the first direct voltage is always applied to the anode of the photodiode 62b. Application of the first direct voltage to the anode during a first period (corresponding to a period prior to the timing to start the period (2) in Figs. 5 and 6) makes the photodiode 62b conductive in a forward direction. During a second period following the first period (the second period corresponds to the period (2) in Figs. 5 and 6), while the first direct voltage is applied to the anode, a read pulse (second pulse) Prw is applied to the other end of the capacitor 62c to change the voltage VnetA at the node netA so that a reverse biased voltage is applied to the photodiode 62b. While the read pulse Prw is applied, an output from the TFT 62a is obtained.

With the arrangement, it is unnecessary to specify timing of pulse to be applied to the reset line Vrst. Accordingly, timing setting is further easier than the methods of Figs. 5 and 6.

The following explains detailed pattern positioning of a display region in accordance with the present embodiment.

Fig. 7 is a plan view of a part of a display region which is a first pattern positioning example in accordance with the present embodiment. This is a pattern view corresponding to the circuit diagram of (a) of Fig. 1. Further, Fig. 8 is a cross sectional view of a picture element PIX taken along a line A-A' of Fig. 7, Fig. 9 is a cross sectional view of the photodiode 62b taken along a line B-B' of Fig. 7, and Fig. 10 is a cross sectional view of the TFT 62a and the capacitors 62c and 62d taken along a line C-C' of Fig. 7.

It should be noted that Fig. 7 shows a case where the sensor output line Vom and the power source line Vsm are provided independently of the source line S.

In the first pattern positioning example, as shown in Figs. 8-10, the node netA is positioned to be the lowest layer in conductive layers on an insulating substrate 1 of a TFT substrate 71.

The TFT substrate 71 includes the insulating substrate 1, a gate metal 2, a gate insulating film 3, an amorphous silicon semiconductor layer 4, an n$^+$ amorphous silicon contact layer 5, a source metal 6, a passivation film 7, and a transparent electrode TM which are layered in this order. An alignment film may be provided on a picture element electrode 63. Further, a phototransistor 62b is formed by connecting a gate and a drain of a TFT.

A gate electrode 61g of a TFT 61, a retention capacitor line Csn, a reset line Vrstn, a read control line Vrwn, a gate electrode 62ag of the TFT 62a, and a node netA are made of the gate metal 2. Source lines S (Sm, Sm+1, ...), a source electrode 61s of the TFT 61, a drain electrode 61d of the TFT 61, a source electrode 62bs of a photodiode 62b, a drain electrode 62bd of the photodiode 62b, a sensor output line Vom doubling as a source electrode 62as of the TFT 62a, a power source line Vsm doubling as a drain electrode 62ad of the TFT 62a, and an electrode 62ca positioned oppositely to the node netA of the capacitor 62c are made of the source metal 6. The picture element electrode 63 and an electrode 64 of the capacitor 62d which electrode is closer to the node netA (electrode at one end of a second capacitor) are made of a transparent electrode TM.

Further, the picture element electrode 63 and the drain electrode 61d of the TFT 61 are connected with each other via a contact hole 8a in the passivation film 7. The drain electrode 62bd of the photodiode 62b and the reset line Vrstn are connected with each other via a contact hole 8b in the gate insulating film 3. The electrode 62ca of the capacitor 62c and the read control line Vrwn are connected with each other via a contact hole 8c in the gate insulating film 3. A connection between the electrode 64 of the capacitor 62d and the source electrode 62bs of the photodiode 62b, and a connection between the source electrode 62bs and the node netA are each made via a contact hole portion 8d consisting of a contact hole in the passivation film 7 and a contact hole in the gate insulating film 3.

The counter substrate 72 includes an insulating substrate 1, a color filter 20, a black matrix 21, and a counter electrode Com which are layered in this order. An alignment film may be provided on the counter electrode Com. The counter electrode Com is made of a transparent electrode TM. Further, an area of the sensor circuit 62 is totally covered by the black matrix 21 in order to block external light other than backlight used in the light detection operation.

As described above, the electrode 64 is in a layer of the TFT substrate 71 which layer is closer to the common electrode (electrode at the other end of second capacitor) Com than the passivation film 7 is.

In the first pattern positioning example, since the distance between electrodes of the capacitor 62d is small, capacitance Ccvr of the capacitor 62d can be large. This enables improving sensitivity in detecting an applied pressure and improving resistivity against a noise caused by incident light. That is, this enables improving accuracy in detecting an applied pressure. Further, since the distance between the electrodes of the capacitor 62d is small, the capacitance Ccvr can be large even if the area of the electrode of the capacitor 62d is small. This enables improving sensitivity in detecting an applied pressure even if the area occupied by the sensor circuit 62 is small, thereby making the sensor circuit 62 highly integrated and improving an open area ratio of the display region. Further, since the node netA is made of the gate metal 2, a connection between the node netA and the gate electrode 62ag of the TFT 62a can be made easily.

Figs. 11-14 show a second pattern positioning example in accordance with the present embodiment. Fig. 11 is a plan view. Fig. 12 is a cross sectional view taken along a line A-A' of Fig. 11. Fig. 13 is a cross sectional view taken along a line B-B' of Fig. 11. Fig. 14 is a cross sectional view taken along a line C-C' of Fig. 11. Members similar to those in Figs. 8-10 are given the same reference signs. A sensor circuit (first circuit) 62' is formed instead of the sensor circuit 62. A node netA is positioned to be the lowest layer in conductive layers on an insulating substrate 1 of a TFT substrate 71. It should be noted that unlike the first pattern positioning example, the electrode 64 for forming the capacitor 62d is not provided. Instead, a capacitor (second capacitor) 62d' is formed between a common electrode Com and a layer of a node netA (electrode at one end of second capacitor). A connection between a source electrode 62bs of a photodiode 62b and the node netA is made via a contact hole 8d' in a gate insulating film 3.

As described above, the node netA serving as an electrode at one end of the second capacitor is in a layer of the TFT substrate 71 which layer is positioned to be farer from the common electrode Com than the passivation layer 7 is.

Further, an area of the sensor circuit 62' is totally covered by a black matrix 21 in order to block external light other than backlight used in the light detection operation.

In the second pattern positioning example, the capacitor 62d' having small capacitance is formed between the common electrode Com and the node netA which is positioned away from the common electrode Com. Accordingly, if the area of the electrode of the capacitor 62d' is the same as that of the capacitor 62d in the first pattern positioning example, capacitance Ccvr of the capacitor 62d' is smaller than that of the capacitor 62d in the first pattern example. However, by designing the sensor circuit 62 to occupy a larger area, the area of the electrode can be larger, so that the capacitance Ccvr of the capacitor 62d' can be large enough not to deteriorate sensitivity in detecting an applied pressure. In this case, it is unnecessary to form an electrode of the capacitor 62d on the passivation film 7, and accordingly pattern processing of the sensor circuit 62 can be made easily. Further, since the node netA is made of the gate metal 2, a connection between the node netA and a gate electrode 62ag of a TFT 62a can be made easily.

Fig. 15 is a plan view of a part of a display region which is a third pattern positioning example in accordance with the present embodiment. This is a pattern view corresponding to the circuit diagram of (a) of Fig. 1. Further, Fig. 16 is a cross sectional view of a picture element PIX taken along a line A-A' of Fig. 15, Fig. 17 is a cross sectional view of the photodiode 62b taken along a line B-B' of Fig. 15, and Fig. 18 is a cross sectional view of a TFT 62a and capacitors 62c and 62d taken along a line C-C' of Fig. 15.

It should be noted that Fig. 15 shows a case where the sensor output line Vom and the power source line Vsm are provided independently of the source line S.

In the third pattern positioning example, as shown in Figs. 16-18, the node netA is one of conductive layers on an insulating substrate 1 which one is positioned above the bottom layer of the conductive layers and is positioned between a gate insulating film 3 and a passivation film 7.

The TFT substrate 71 includes an insulating substrate 1, a gate metal 2, a gate insulating film 3, an amorphous silicon semiconductor layer 4, an n⁺ amorphous silicon contact layer 5, a source metal 6, a passivation film 7, and a transparent electrode TM which are layered in this order. An alignment film may be provided on a picture element electrode 63. Further, a phototransistor 62b is formed by connecting a gate and a drain of a TFT.

A gate electrode 61g of a TFT 61, a retention capacitor line Csn, a reset line Vrstn, a gate electrode 62ag of a TFT 62a, a read control line Vrwn, an electrode 62ca of a capacitor 62c which electrode is closer to the read control line Vrwn, and connection pad layers 9 and 10 are made of the gate metal 2. The connection pad 9 is wiring via which the node netA and the gate electrode 62ag of the TFT62a are connected with each other. The connection pad layer 10 is wiring via which a source electrode 62bs of a photodiode 62b and the node netA are connected with each other. Source lines S (Sm, Sm+1, ...), a source electrode 61s of the TFT 61, a drain electrode 61d of the TFT 61, a source electrode 62bs of a photodiode 62b, a drain electrode 62bd of the photodiode 62b, a sensor output line Vom doubling as a source electrode 62as of the TFT 62a, a power source line Vsm doubling as a drain electrode 62ad of the TFT 62a, and the node netA are made of the source metal 6. The picture element electrode 63 and an electrode 64 of the capacitor 62d which electrode is closer to the node netA (electrode at one end of a second capacitor) are made of the transparent electrode TM.

Further, the picture element electrode 63 and the drain electrode 61d of the TFT 61 are connected with each other via a contact hole 8a in the passivation film 7. The drain electrode 62bd of the photodiode 62b and the reset line Vrstn are connected with each other via a contact hole 8b in the gate insulating film 3. The node netA and the connection pad 9 are connected with each other via a contact hole 8c in the gate insulating film 3. The node netA and the connection pad 10 are connected with each other via a contact hole 8d in the gate insulating film 3. The source electrode 62bs of the photodiode 62b and the connection pad 10 are connected with each other via a contact hole 8e in the gate insulating film 3. The electrode 64 of the capacitor 62d which electrode is closer to the node netA and the node net A are connected with each other via a contact hole 8f in the passivation film 7.

The counter substrate 72 includes an insulating substrate 1, a color filter 20, a black matrix 21, and a counter electrode Com which are layered in this order. An alignment film may be provided on the counter electrode Com. The counter electrode Com is made of a transparent electrode TM. Further, an area of the sensor circuit 62 is totally covered by the black matrix 21 in order to block external light other than backlight used in the light detection operation.

As described above, the electrode 64 is in a layer of the TFT substrate 71 which layer is closer to the common electrode (electrode at the other end of second capacitor) Com than the passivation film 7 is.

In the third pattern positioning example, since the distance between electrodes of the capacitor 62d is small, capacitance Ccvr of the capacitor 62d can be large. This enables improving sensitivity in detecting an applied pressure and improving resistivity against a noise caused by incident light. That is, this enables improving accuracy in detecting an applied pressure. Further, since the distance between the electrodes of the capacitor 62d is small, the capacitance Ccvr can be large even if the area of the electrode of the capacitor 62d is small. This enables improving sensitivity in detecting an applied pressure even if the area occupied by the sensor circuit 62 is small, thereby making the sensor circuit 62 highly integrated and improving an open area ratio of the display region. Further, since the node netA is made of the source metal 6, a connection between the node netA and the electrode 64 of the capacitor 62d and a connection between the node netA and the source electrode 62bs of the photodiode 62b can be made easily.

Figs. 19-22 show a comparative example of the fourth pattern positioning example. Fig. 19 is a plan view, Fig. 20 is a cross sectional view taken along a line A-A' of Fig. 19, Fig. 21 is a cross sectional view taken along a line B-B' of Fig. 19, and Fig. 22 is a cross sectional view taken along a line C-C' of Fig. 19. Members similar to those in Figs. 15-18 are given the same reference signs. A sensor circuit (first circuit) 62' is provided instead of the sensor circuit 62. The node netA is one of conductive layers on an insulating substrate 1 which one is positioned above the bottom layer of the conductive layers and is positioned between a gate insulating film 3 and a passivation film 7. However, unlike the third pattern positioning example, the electrode 64 for forming the capacitor 62d is not provided, and instead a capacitor (second capacitor) 62d' is formed between the common electrode Com and the node (electrode at one end of second capacitor) netA.

As described above, the node netA serving as an electrode at one end of the second capacitor is in a layer of the TFT substrate 71 which layer is positioned to be farer from the common electrode Com than the passivation layer 7 is.

Further, an area of the sensor circuit 62' is totally covered by a black matrix 21 in order to block external light other than backlight used in the light detection operation.

In the fourth pattern positioning example, the capacitor 62d' having small capacitance is formed between the common electrode Com and the node netA which is positioned away from the common electrode Com. Accordingly, if the area of the electrode of the capacitor 62d' is the same as that of the capacitor 62d in the third pattern positioning example, capacitance Ccvr of the capacitor 62d' is smaller than that of the third capacitor 62d in the third pattern positioning example. However, by designing the sensor circuit 62 to occupy a larger area, the area of the electrode can be larger, so that the capacitance Ccvr of the capacitor 62d' can be large enough not to deteriorate sensitivity in detecting an applied pressure. In this case, it is unnecessary to form an electrode of the capacitor 62d on the passivation film 7, and accordingly pattern processing of the sensor circuit 62' can be made easily. Further, since the node netA is made of the source metal 6, a connection between the node netA and a source electrode 62bs of a photodiode 62b can be made easily.

With reference to Figs. 23 to 28, the following explains Examples of alternative use of the operation in the light detection mode (second operation) and the operation in the pressure detection mode (first operation) of the liquid crystal display device 50 in accordance with the present embodiment.


[First example]

The present Example relates to alternative use of the operation in the light detection mode and the operation in the pressure detection mode of the optical sensor circuit 62.

In the present Example, when using software for the operation in the light detection mode or software for the operation in the pressure detection mode as shown in Fig. 24, execution of individual software is detected so as to determine which mode the sensor circuit 62 is operated in. For convenience of explanation, the software for the operation in the light detection mode and the software for the operation in the pressure detection mode are different application software. Alternatively, the two software may be included in single application software.

It is assumed in Fig. 24 for example that scanner software and music-playing software are used in the liquid crystal display device 50. These software are stored in an external computer including the sensing image processor 57. Initially, in (1), when execution of the scanner software is started, the scanner software instructs the sensor scanning signal line drive circuit 54 to perform light detection drive. Consequently, the sensor scanning signal line drive circuit 54 outputs to the sensor circuit 62 a reset pulse Prst and a read pulse Prwn according to a sequence for the light detection mode. In the light detection mode, when a visiting card is put above a screen as shown in (2) in order to scan the visiting card, the sensor circuit 62 reads an image of the visiting card as shown in (2') by using reflection of backlight. When the visiting card is removed from the screen as shown in (3), the image of the visiting card is not recognized as shown in (3').

Subsequently, when execution of the scanner software is finished and execution of the music-playing software is started in (4), the music-playing software instructs the sensor scanning signal line driving circuit 54 to perform pressure detection drive. Consequently, the sensor scanning signal line drive circuit 54 outputs to the sensor circuit 62 a reset pulse Prst and a read pulse Prwn according to a sequence for the pressure detection mode. In the pressure detection mode, when a predetermined touch sensing area displayed on a screen is pressed by a finger, a stylus etc. as shown in (5), coordinates of the pressed area are detected as shown in (5') and the sound corresponding to the pressed area is emitted from a speaker. Further, when pressing a plurality of touching areas as shown in (6), it is possible to simultaneously emit sounds corresponding to the pressed areas, respectively, as shown in (6').

Fig. 23 is a signal waveform chart showing the operation of the sensor circuit 62 switching between the light detection drive and the pressure detection drive.

Switching instruction is made by a mode control signal s1 supplied from the sensing image processor 57 to the sensor scanning signal line drive circuit 54. The mode control signal s1 is a pulse signal as shown in Fig. 23 for example. The mode control signal s1 is generated in a computer when switching between the light detection drive and the pressure detection drive in response to start of execution of the scanner software or the music-playing software. The mode control signal s1 for instructing the sensor scanning signal line drive circuit 54 to perform the light detection drive is referred to as a first control signal, and the mode control signal s1 for instructing the sensor scanning signal line drive circuit 54 to perform the pressure detection drive is referred to as a second control signal. When the mode control signal s1 is supplied to the sensor scanning signal line drive circuit 54, one of the first control signal and the second control signal is selected and supplied. In the present Example, generally, with respect to a screen to be displayed next to the currently displayed screen, which of the first control signal and the second control signal is to be supplied to the sensor scanning signal line drive circuit 54 is determined based on data of the screen to be displayed next. The currently displayed screen includes a screen at the time when the power of the display deice is OFF.

Fig. 23 shows an example in which one of the light detection drive and the pressure detection drive is once started in response to the mode control signal s1, the sensor circuit 62 repeats, with respect to every one vertical period (1V), the operation in the light detection mode when the light detection drive is performed, and the operation in the pressure detection mode when the pressure detection drive is performed, until the mode control signal s1 for switching the present detection drive to the other detection drive is generated. In the case of the light detection drive, a difference in the sensor output voltage Vo of D.R.1 occurs depending on whether light is incident to the photodiode 62b or not, thereby determining whether light is detected or not. In the case of the pressure detection drive, a difference in the sensor output voltage of D.R.2 occurs depending on whether pressure is applied or not, thereby determining whether pressure is detected or not.

The mode control signal s1 may be a pulse which is supplied at timing of transition from a light detection drive period to a pressure detection drive period or vice versa as shown in the second graph from the bottom of Fig. 23 and which instructs the sensor scanning signal line drive circuit 54 to switch between the light detection drive and the pressure detection drive. For example, assume that there are provided the mode control signal s1 for the light detection drive and the mode control signal s1 for the pressure detection drive. The sensor scanning signal line drive circuit 54 receives the mode control signal s1 and performs logical operation of a start pulse and the mode control signal s1 to generate a shift pulse for the light detection drive or a shift pulse for the pressure detection drive, and inputs the generated pulse into a shift register in the sensor scanning signal line drive circuit 54. By differentiating the mode control signal s1 for the light detection drive and the mode control signal s1 for the pressure detection drive from each other in terms of a pulse width, a pulse polarity, phase difference with respect to a predetermined timing signal etc., logical operation with the same start pulse generates different pulses in terms of timing, a pulse width, amplitude, polarity etc. Accordingly, it is possible to generate a reset pulse Prst1 for the light detection drive, a reset pulse Prst2 for the pressure detection drive, and the read pulse Prwn. The same can be applied to other Examples.

Alternatively, the sensor scanning signal line drive circuit 54 may be arranged such that on reception of the mode control signal s1, the sensor scanning signal line drive circuit 54 switches between input of a start pulse into a shift register for the light detection drive and input of a start pulse into a shift register for the pressure detection drive by use of a switch for determining an input route. The shift register for the light detection drive and the shift register for the pressure detection drive are included in the sensor scanning signal line drive circuit 54. The switch may be designed to switch shift registers to which a start pulse is to be inputted depending on whether the mode control signal s1 is for the light detection drive or the pressure detection drive, or may be designed such that every time a pulse of the mode control signal s1 with the single pulse polarity is inputted, the switch switches between input of a start pulse into the shift register for the light detection drive and input of a start pulse into the shift register for the pressure detection drive. Timing, pulse width, and amplitude of reset pulses Prst1 and Prst2 and a read pulse Prwn can be set individually. Further, as shown in Fig. 1, if the read pulse Prwn has constant timing and constant waveform, only the reset pulses Prst1 and Prst2 may be generated separately for the light detection drive and the pressure detection drive.

Further, as shown in the graph at the bottom of Fig. 23, the mode control signal s1 may be an enable signal which determines the output period of a High voltage of the reset pulse Prst in order to give instruction to set the pulse width of the reset pulse Prst for the light detection drive (Prst1) or for the pressure detection drive (Prst2) at timing of the reset pulse Prst.

Fig. 25 is a flowchart for carrying out the operations in Figs. 23 and 24. Here, as an example, the subject of the operation is the sensing image processor 57 in a computer. Alternatively, the subject of the operation may be a control section (e.g. normal liquid crystal controller) provided at any position (inside or outside position) of the liquid crystal display device 50. The same can be applied to other Examples.

Initially, in step S11, when certain application software is started, it is determined whether the scanner function (i.e. light detection mode) or the touch panel function (i.e. pressure detection mode) is required or not. When it is determined that the scanner function or the touch panel function is required in step S11, the process goes to step S12, and it is determined whether a mode control signal s1 required for the started application software is for the light detection drive or for the pressure detection drive. When it is determined that the scanner function or the touch panel function is required in step S11, the process is finished.

Subsequently, the process goes to step S13. The required mode control signal s1 for which determination was made in step S12 is selected and set. Consequently, the mode control signal s1 is supplied from the sensing image processor 57 for example to the sensor scanning signal line drive circuit 54. Subsequently, the process goes to step S14, and the sensor scanning signal line drive circuit 54 is caused to perform the light detection drive or the pressure detection drive, so that the sensor read circuit 55 is caused to read an optically sensed image or data corresponding to a change in capacitance, and the sensing image processor 57 performs calculation, based on the result of detection obtained from the sensor read circuit 55, to determine whether an input point exists or not on the screen.

In the next step S15, based on the result of the calculation, it is determined whether the input point exists or not on the screen. When the input point exists, the process goes to step S16. When the input point does not exist on the screen, the process goes back to step S14. In step 16, it is determined to which one of predetermined patterns the number of sensing points constituting the input point and coordinates of the input point on the screen correspond. Step S17 diverges into individual processes corresponding to the patterns corresponding to the number of the input points and the coordinates of the input points, and the processes are carried out.

When step S17 is finished, the process goes back to the first step. When the application software is ended, the whole process is finished.

[Second example]

The present Example is based on switching between the light detection drive and the pressure detection drive in response to the mode control signal s1 described in First Example. An explanation will be made as to an operation of starting the light detection drive with a trigger of detection of a pressure by the sensor circuit 62 in the pressure detection mode.

In the present Example, as shown in Fig. 27, application of a pressure on an area of the sensor circuit 62 operating in the pressure detection mode causes transition to the light detection drive. The area of the sensor circuit 62 operating in the pressure detection mode is designed to be displayed as a default menu area on the screen when, for example, certain application software is started. The area of the sensor circuit 62 may be an area spreading over the whole screen instead of the menu area. (1) indicates a state where no pressure is applied to the area, and detection of an applied pressure or detection of light is not made when a finger comes close to the area as shown in (1').

Subsequently, as shown in (2), when a user wants to cause the application software to carry out the scanner function, the user applies by a finger a pressure to an operation area of the pressure detection mode which is displayed as the menu area. At that time, where the pressure is applied is detected as shown in (2'). As a result of the detection of the pressure, the liquid crystal display device 50 recognizes necessity to transit to the light detection drive, and starts the light detection drive. In the light detection mode, when a finger touches the screen (or a finger presses the screen) so that the finger is scanned as shown in (3), data of a fingerprint is obtained as shown in (3'). Further, data of the shadow of an approaching hand may be simultaneously obtained as shown in (3') so that detection different from detection of an applied pressure is made. The area on the screen to be touched by a finger to obtain a fingerprint may be a one changed from the menu area of the sensor circuit 62 operating in the pressure detection mode in advance, or may be a one different from the menu area.

Release of the light detection mode may be made in such a manner that leaving the mode for a predetermined time leads to the release, or pressing the same menu area again leads to the release, or pressing other menu area leads to the release etc.

In the present Example as well as in First example, the mode control signal s1 for instructing the sensor scanning signal line drive circuit 54 to perform the light detection drive is referred to as a first control signal, and the mode control signal s1 for instructing the sensor scanning signal line drive circuit 54 to perform the pressure detection drive is referred to as a second control signal. When the mode control signal s1 is supplied to the sensor scanning signal line drive circuit 54, one of the first control signal and the second control signal is selected and supplied. In the present Example, which of the first control signal and the second control signal is to be supplied to the sensor scanning signal line drive circuit 54 is determined based on whether a pressure is applied to a predetermined area of a display surface for which the sensor circuit 62 operates as a pressure detection circuit on the currently displayed screen. The currently displayed screen includes a screen at the time when the power of the display deice is OFF.

Fig. 26 is a signal waveform chart showing the operation of causing the sensor circuit 62 to start the light detection drive.

The sensor scanning signal line drive circuit 54 outputs beforehand a reset pulse Prst2 and a read pulse Prwn each for the pressure detection drive. For example, when a sensor output voltage Vom drops by D.R compared with a case when no pressure is applied, the sensing image processor 57 recognizes that a pressure is applied, and supplies to the sensor scanning signal line drive circuit 54 the mode control signal s1 for causing the sensor scanning signal line drive circuit 54 to start the light detection drive. Consequently, the sensor scanning signal line drive circuit 54 starts the light detection drive, and the target sensor circuit 62 operates in the light detection mode.

Fig. 28 is a flowchart for the operations in Figs. 26 and 27.

Initially, in step S21, when certain application software is started, it is determined whether one of light detection and pressure detection is necessary or not. When it is determined that one of light detection and pressure detection is necessary, the process goes to step S22, and when it is determined that none of light detection and pressure detection is necessary, the process is finished. In step S22, it is determined whether the started software requires light detection means such as a scanner or not. When the started software requires the light detection means, the mode control signal s1 for the light detection drive is outputted, steps S14 to S17 in Fig. 25 are carried out and then the process is finished. When the started software does not require the light detection means, the mode control signal s1 for the pressure detection is outputted and the process goes to step S23.

In step S23, the sensor read circuit 55 is caused to obtain sensing data corresponding to a change in capacitance, and the sensing image processor 57 makes calculation, based on the result of detection obtained from the sensor read circuit 55, to determine whether an input point exists or not on the screen. In the next step S24, it is determined whether the input point exists or not on the screen based on the result of the calculation. When the input point exists, the process goes to step S25. When the input point does not exist, the process goes back to step S23.

In step S25, the sensor read circuit 55 is caused to obtain an optically sensed image and the sensing image processor 57 calculates coordinates of the input point based on the result of the detection obtained from the sensor read circuit 55. In the next step S26, processes according to the sensed image are carried out based on the result in step S25.

When step S26 is finished, the process goes to the first step, and when execution of the application software is finished, the whole process is finished.

The present Embodiment has been explained as above. Examples of the photodiode used in the present invention are not limited to the transistors mentioned in the first to fourth pattern positioning examples, such as field-effect transistors and bipolar transistors (including phototransistors) which are diode-connected. Examples of the photodiode used in the present invention also include photodiodes having normal diode laminate structures, such as pin-photodiodes. That is, the photodiode used in the present invention may be any device whose current-voltage properties have diode properties and whose internal conductivity changes due to irradiation with light.

In order to solve the foregoing problems, a display device of the present invention includes, in a display region, a first circuit including a photodiode, a first capacitor, a second capacitor, and an output amplifier, a cathode of the photodiode, one end of the first capacitor, one end of the second capacitor, and an input of the output amplifier being connected with one another via a first node, an electrode at the other end of the second capacitor being provided on a substrate having a display surface of a display panel, and an electrode at the one end of the second capacitor being positioned to be away from the display surface in a thickness direction of the display panel in such a manner as to face the electrode at the other end of the second capacitor.

With the invention, capacitance of the second capacitor changes since application of a pressure to the display surface causes a change of the electrode at the other end of the second capacitor and the distance between the electrode at the one end and the electrode at the other end of the second capacitor changes. Consequently, the second capacitor serves as a detection element of a touch sensor, and the first circuit serves as a touch sensor. When using the first circuit as an optical sensor, leakage in the photodiode in accordance with intensity of light incident to the photodiode is detected. When using the first circuit as a touch sensor, the photodiode is made conductive in a forward direction and then a voltage is applied to the electrode of the other end of the first capacitor so that a reverse biased voltage is applied to the photodiode, and an output according to the voltage at the first node is obtained from the output amplifier.

Therefore, it is possible to realize a display device including a low-priced, downsized, and highly reliable touch panel function without deteriorating a display function.

In order to solve the foregoing problems, a display device of the present invention includes, in a display region, a first circuit including a photodiode, a first capacitor, a second capacitor, and an output amplifier, a cathode of the photodiode, one end of the first capacitor, one end of the second capacitor, and an input of the output amplifier being connected with one another via a first node, an electrode at the other end of the second capacitor being provided on a substrate having a display surface of a display panel, an electrode at the one end of the second capacitor being positioned to be away from the display surface in a thickness direction of the display panel in such a manner as to face the electrode at the other end of the second capacitor, a first direct voltage being applied to an anode of the photodiode, application of the first direct voltage to the anode during a first period making the photodiode conductive in a forward direction, while the first direct voltage is applied to the anode during a second period following the first period, a second pulse being applied to the other end of the first capacitor to change a voltage at the first node so that a reverse biased voltage is applied to the photodiode, and while the second pulse is applied, an output from the output amplifier being obtained.

With the invention, capacitance of the second capacitor changes since application of a pressure to the display surface causes a change of the electrode at the other end of the second capacitor and the distance between the electrode at the one end and the electrode at the other end of the second capacitor changes. Consequently, the second capacitor serves as a detection element of a touch sensor, and the first circuit serves as a touch sensor. The first direct voltage is applied to the anode of the photodiode, and application of the first direct voltage during the first period makes the photodiode conductive in a forward direction, so that the voltage at the first node is substantially equal to the first direct voltage.

During the second period, while the first direct voltage is applied to the anode, the second pulse is applied to the other end of the first capacitor to change the voltage at the first node so that a reverse biased voltage is applied to the photodiode. At that time, the voltage at the first node is determined depending on a ratio in capacitance of the first capacitor to the second capacitor. Capacitance of the first capacitor is not changed by application of a pressure, but capacitance of the second capacitor is changed. Accordingly, the output voltage changes in accordance with capacitance of the second capacitor. Since the output of the output amplifier is obtained while the second pulse is applied, it is possible to detect whether a pressure is applied to the display surface or not.

The detection of the applied pressure is made while the second pulse is applied. Accordingly, even if light is incident to the photodiode, there is little possibility that leakage in the photodiode in a reverse biased state changes the voltage at the first node. Therefore, it is possible to prevent the incident light from being a noise which changes the voltage at the first node in the pressure detection operation.

Therefore, it is possible to realize a display device including a low-priced, downsized, and highly reliable touch panel function without deteriorating a display function. Further, since the first direct voltage is not a pulse but a DC voltage, it is unnecessary to determine timing. Thus, setting of timing is further easier.

In order to solve the foregoing problems, a display device of the present invention includes, in a display region, a first circuit including a photodiode, a first capacitor, a second capacitor, and an output amplifier, a cathode of the photodiode, one end of the first capacitor, one end of the second capacitor, and an input of the output amplifier being connected with one another via a first node, an electrode at the other end of the second capacitor being provided on a substrate having a display surface of a display panel, an electrode at the one end of the second capacitor being positioned to be away from the display surface in a thickness direction of the display panel in such a manner as to face the electrode at the other end of the second capacitor, a first pulse being applied to an anode of the photodiode so as to make the photodiode conductive in a forward direction, while the first pulse is applied, a second pulse being applied to the other end of the first capacitor to change a voltage at the first node so that a reverse biased voltage is applied to the photodiode, and while the second pulse is applied, an output from the output amplifier being obtained.

With the invention, capacitance of the second capacitor changes since application of a pressure to the display surface causes a change of the electrode at the other end of the second capacitor and the distance between the electrode at the one end and the electrode at the other end of the second capacitor changes. Consequently, the second capacitor serves as a detection element of a touch sensor, and the first circuit serves as a touch sensor. Application of the first pulse to the anode of the photodiode makes the photodiode conductive in a forward direction, so that the voltage at the first node is substantially equal to a High level voltage of the first pulse.

In that state, the second pulse is applied to the other end of the first capacitor to change the voltage at the first node so that a reverse biased voltage is applied to the photodiode. At that time, the voltage at the first node is determined depending on a ratio in capacitance of the first capacitor to the second capacitor. Capacitance of the first capacitor is not changed by application of a pressure, but capacitance of the second capacitor is changed. Accordingly, the output voltage changes in accordance with capacitance of the second capacitor. Since the output of the output amplifier is obtained while the second pulse is applied, it is possible to detect whether a pressure is applied to the display surface or not.

The detection of the applied pressure is made while the second pulse is applied. Accordingly, even if light is incident to the photodiode, there is little possibility that leakage in the photodiode in a reverse biased state changes the voltage at the first node. Therefore, it is possible to prevent the incident light from being a noise which changes the voltage at the first node in the pressure detection operation.

Therefore, it is possible to realize a display device including a low-priced, downsized, and highly reliable touch panel function without deteriorating a display function.

In this case, a reverse biased voltage applied to the photodiode while the second pulse is applied is relatively small, so that a difference in internal conductivity due to a difference in intensity of light incident to the photodiode is small. Accordingly, a noise due to incident light in the pressure detection operation is reduced to the minimum, achieving a very high accuracy in detection of an applied pressure.

In order to solve the foregoing problems, a display device of the present invention includes, in a display region, a first circuit including a photodiode, a first capacitor, a second capacitor, and an output amplifier, a cathode of the photodiode, one end of the first capacitor, one end of the second capacitor, and an input of the output amplifier being connected with one another via a first node, an electrode at the other end of the second capacitor being provided on a substrate having a display surface of a display panel, an electrode at the one end of the second capacitor being positioned to be away from the display surface in a thickness direction of the display panel in such a manner as to face the electrode at the other end of the second capacitor, a first pulse being applied to an anode of the photodiode so as to make the photodiode conductive in a forward direction, during a period following a period in which the first pulse is applied, a second pulse being applied to the other end of the first capacitor to change a voltage at the first node so that a reverse biased voltage is applied to the photodiode, and while the second pulse is applied, an output from the output amplifier being obtained.

With the invention, capacitance of the second capacitor changes since application of a pressure to the display surface causes a change of the electrode at the other end of the second capacitor and the distance between the electrode at the one end and the electrode at the other end of the second capacitor changes. Consequently, the second capacitor serves as a detection element of a touch sensor, and the first circuit serves as a touch sensor. Application of the first pulse to the anode of the photodiode makes the photodiode conductive in a forward direction, so that the voltage at the first node is substantially equal to a High level voltage of the first pulse.

In that state, the second pulse is applied to the other end of the first capacitor to change the voltage at the first node so that a reverse biased voltage is applied to the photodiode. At that time, the voltage at the first node is determined depending on a ratio in capacitance of the first capacitor to the second capacitor. Capacitance of the first capacitor is not changed by application of a pressure, but capacitance of the second capacitor is changed. Accordingly, the output voltage changes in accordance with capacitance of the second capacitor. Since the output of the output amplifier is obtained while the second pulse is applied, it is possible to detect whether a pressure is applied to the display surface or not.

The detection of the applied pressure is made while the second pulse is applied. Accordingly, even if light is incident to the photodiode, there is little possibility that leakage in the photodiode in a reverse biased state changes the voltage at the first node. Therefore, it is possible to prevent the incident light from being a noise which changes the voltage at the first node in the pressure detection operation.

Therefore, it is possible to realize a display device including a low-priced, downsized, and highly reliable touch panel function without deteriorating a display function.

Further, it is possible to easily set timing of applying the second pulse by using end timing of the first pulse.

Further, since it is possible to shorten the period of the first pulse, a noise caused by light incident to the photodiode conductive in a forward direction during the period of the first pulse can be reduced to the minimum. Therefore, it is possible to further improve accuracy in detecting an applied pressure.

In order to solve the foregoing problems, the display device of the present invention may be arranged such that the display device is a liquid crystal display device, and the electrode at the other end of the second capacitor is a common electrode.

With the invention, the common electrode can be used for a touch sensor. Accordingly, it is unnecessary to separately provide an electrode at the other end of the second capacitor.

In order to solve the foregoing problems, the display device of the present invention may be arranged such that the electrode at one end of the second capacitor is in a layer in a matrix substrate which layer is positioned to be closer to the electrode at the other end of the second capacitor than a passivation film in the matrix substrate is.

With the invention, the distance between the electrode at the one end of the second capacitor and the electrode at the other end is small, so that capacitance of the second capacitor can be large. Accordingly, it is possible to improve sensitivity in detecting an applied pressure and improve resistivity to a noise due to incident light, that is, it is possible to improve accuracy in detecting an applied pressure.

Further, since the distance between the electrodes of the second capacitor is small, capacitance of the second capacitor can be large even if the area of the electrode of the second capacitor is small. Accordingly, even if the area occupied by the first circuit is small, accuracy in detecting an applied pressure can be improved, so that it is possible to make the first circuit highly integrated and improve an open area ratio of the display region.

In order to solve the foregoing problems, the display device of the present invention may be arranged such that the electrode at the one end of the second capacitor is a transparent electrode positioned at a same layer as a layer where picture element electrodes are positioned, and a liquid crystal layer is positioned between the electrode at the one end of the second capacitor and the electrode at the other end of the second capacitor.

With the invention, the layer of the transparent electrode constituting the picture element electrode of the liquid crystal display device is used as the electrode at the one end of the second capacitor, and the liquid crystal layer is used as a main dielectric material of a capacitor. Accordingly, the second capacitor can be easily formed.

In order to solve the foregoing problems, the display device of the present invention may be arranged such that the electrode at one end of the second capacitor is in a layer in a matrix substrate which layer is positioned to be farer from the electrode at the other end of the second capacitor than a passivation film in the matrix substrate is.

With the invention, the electrode at the one end of the second capacitor can be easily made of an existing layer of the matrix substrate.

In order to solve the foregoing problems, the display device of the present invention may be arranged such that the electrode at the one end of the second capacitor is made of a gate metal.

With the invention, the electrode at the one end of the second capacitor can be easily made of an existing gate metal of the matrix substrate.

In order to solve the foregoing problems, the display device of the present invention may be arranged such that the electrode at the one end of the second capacitor is made of a source metal.

With the invention, the electrode at the one end of the second capacitor can be easily made of an existing source metal of the matrix substrate.

In order to solve the foregoing problems, the display device of the present invention may be arranged such that the first node is made of a gate metal.

With the invention, the first node is made of a gate metal. Accordingly, it is easy to connect the first node with a gate electrode of a field effect transistor when used in the output amplifier.

In order to solve the foregoing problems, the display device of the present invention may be arranged such that the first node is made of a source metal.

With the invention, the first node is made of a source metal. Accordingly, it is easy to connect the first node with the electrode at the one end of the second capacitor or a source electrode of a photodiode constituted by field effect transistors which are diode-connected.

In order to solve the foregoing problems, a method of the present invention is a method for driving a display device including, in a display region, a first circuit including a photodiode, a first capacitor, a second capacitor, and an output amplifier, a cathode of the photodiode, one end of the first capacitor, one end of the second capacitor, and an input of the output amplifier being connected with one another via a first node, an electrode at the other end of the second capacitor being provided on a substrate having a display surface of a display panel, an electrode at the one end of the second capacitor being positioned to be away from the display surface in a thickness direction of the display panel in such a manner as to face the electrode at the other end of the second capacitor, the method comprising causing the first circuit to carry out a first operation of (i) applying a first direct voltage to an anode of the photodiode so that application of the first direct voltage to the anode during a first period makes the photodiode conductive in a forward direction, (ii) while the first direct voltage is applied to the anode during a second period following the first period, applying a second pulse to the other end of the first capacitor to change a voltage at the first node so that a reverse biased voltage is applied to the photodiode, and (iii) while the second pulse is applied, obtaining an output from the output amplifier.

With the invention, the first direct voltage is applied to the anode of the photodiode. During the first period, the application of the first direct voltage makes the photodiode conductive in a forward direction, so that the voltage at the first node is substantially equal to the first direct voltage.

During the second period, while the first direct voltage is applied to the anode, the second pulse is applied to the other end of the first capacitor to change the voltage at the first node so that a reverse biased voltage is applied to the photodiode. At that time, the voltage at the first node is determined depending on a ratio in capacitance of the first capacitor to the second capacitor. Capacitance of the first capacitor is not changed by application of a pressure, but capacitance of the second capacitor is changed. Accordingly, the output voltage changes in accordance with capacitance of the second capacitor. Since the output of the output amplifier is obtained while the second pulse is applied, it is possible to detect whether a pressure is applied to the display surface or not.

The detection of the applied pressure is made while the second pulse is applied. Accordingly, even if light is incident to the photodiode, there is little possibility that leakage in the photodiode in a reverse biased state changes the voltage at the first node. Therefore, it is possible to prevent the incident light from being a noise which changes the voltage at the first node in the pressure detection operation.

Therefore, it is possible to realize a display device including a low-priced, downsized, and highly reliable touch panel function without deteriorating a display function. Further, since the first direct voltage is not a pulse but a DC voltage, it is unnecessary to determine timing. Thus, setting of timing is further easier.

In order to solve the foregoing problems, a method of the present invention is a method for driving a display device including, in a display region, a first circuit including a photodiode, a first capacitor, a second capacitor, and an output amplifier, a cathode of the photodiode, one end of the first capacitor, one end of the second capacitor, and an input of the output amplifier being connected with one another via a first node, an electrode at the other end of the second capacitor being provided on a substrate having a display surface of a display panel, an electrode at the one end of the second capacitor being positioned to be away from the display surface in a thickness direction of the display panel in such a manner as to face the electrode at the other end of the second capacitor, the method comprising causing the first circuit to carry out a first operation of (i) applying a first pulse to an anode of the photodiode so as to make the photodiode conductive in a forward direction, (ii) while the first pulse is applied, applying a second pulse to the other end of the first capacitor to change a voltage at the first node so that a reverse biased voltage is applied to the photodiode, and (iii) while the second pulse is applied, obtaining an output from the output amplifier.

With the invention, application of the first pulse to the anode of the photodiode makes the photodiode conductive in a forward direction, so that the voltage at the first node is substantially equal to a High level voltage of the first pulse. In that state, the second pulse is applied to the other end of the first capacitor to change the voltage at the first node so that a reverse biased voltage is applied to the photodiode. At that time, the voltage at the first node is determined depending on a ratio in capacitance of the first capacitor to the second capacitor. Capacitance of the first capacitor is not changed by application of a pressure, but capacitance of the second capacitor is changed. Accordingly, the output voltage changes in accordance with capacitance of the second capacitor. Since the output of the output amplifier is obtained while the second pulse is applied, it is possible to detect whether a pressure is applied to the display surface or not.

The detection of the applied pressure is made while the second pulse is applied. Accordingly, even if light is incident to the photodiode, there is little possibility that leakage in the photodiode in a reverse biased state changes the voltage at the first node. Therefore, it is possible to prevent the incident light from being a noise which changes the voltage at the first node in the pressure detection operation.

Therefore, it is possible to realize a display device including a low-priced, downsized, and highly reliable touch panel function without deteriorating a display function.

In order to solve the foregoing problems, a method of the present invention is a method for driving a display device including, in a display region, a first circuit including a photodiode, a first capacitor, a second capacitor, and an output amplifier, a cathode of the photodiode, one end of the first capacitor, one end of the second capacitor, and an input of the output amplifier being connected with one another via a first node, an electrode at the other end of the second capacitor being provided on a substrate having a display surface of a display panel, an electrode at the one end of the second capacitor being positioned to be away from the display surface in a thickness direction of the display panel in such a manner as to face the electrode at the other end of the second capacitor, the method comprising causing the first circuit to carry out a first operation of (i) applying a first pulse to an anode of the photodiode so as to make the photodiode conductive in a forward direction, (ii) during a period following a period in which the first pulse is applied, applying a second pulse to the other end of the first capacitor to change a voltage at the first node so that a reverse biased voltage is applied to the photodiode, and (iii) while the second pulse is applied, obtaining an output from the output amplifier.

With the invention, application of the first pulse to the anode of the photodiode makes the photodiode conductive in a forward direction, so that the voltage at the first node is substantially equal to a High level voltage of the first pulse. In that state, the second pulse is applied to the other end of the first capacitor to change the voltage at the first node so that a reverse biased voltage is applied to the photodiode. At that time, the voltage at the first node is determined depending on a ratio in capacitance of the first capacitor to the second capacitor. Capacitance of the first capacitor is not changed by application of a pressure, but capacitance of the second capacitor is changed. Accordingly, the output voltage changes in accordance with capacitance of the second capacitor. Since the output of the output amplifier is obtained while the second pulse is applied, it is possible to detect whether a pressure is applied to the display surface or not.

The detection of the applied pressure is made while the second pulse is applied. Accordingly, even if light is incident to the photodiode, there is little possibility that leakage in the photodiode in a reverse biased state changes the voltage at the first node. Therefore, it is possible to prevent the incident light from being a noise which changes the voltage at the first node in the pressure detection operation.

Therefore, it is possible to realize a display device including a low-priced, downsized, and highly reliable touch panel function without deteriorating a display function.

Further, it is possible to easily set timing of applying the second pulse by using end timing of the first pulse.

Further, since it is possible to shorten the period of the first pulse, a noise caused by light incident to the photodiode conductive in a forward direction during the period of the first pulse can be reduced to the minimum. Therefore, it is possible to further improve accuracy in detecting an applied pressure.

In order to solve the foregoing problems, the method of the present invention may be arranged such that the display device further includes, in the display region, an optical sensor circuit which includes a light-receiving element and which detects intensity of light incident to the light-receiving element, one of a first control signal for causing the optical sensor circuit to operate and a second control signal for causing the first circuit to carry out the first operation is selected and supplied to a drive circuit of the display device, and with respect to a screen to be displayed next to a currently displayed screen, it is determined which of the first control signal and the second control signal is to be supplied to the drive circuit based on data of the screen to be displayed next.

With the invention, which of the first control signal and the second control signal is to be supplied to the drive circuit can be easily determined based on data of the screen to be displayed next.

In order to solve the foregoing problems, the method of the present invention may be arranged such that the display device further includes, in the display region, an optical sensor circuit which includes a light-receiving element and which detects intensity of light incident to the light-receiving element, one of a first control signal for causing the optical sensor circuit to operate and a second control signal for causing the first circuit to carry out the first operation is selected and supplied to a drive circuit of the display device, and with respect to a screen to be displayed next to a currently displayed screen, it is determined which of the first control signal and the second control signal is to be supplied to the drive circuit based on a result of whether a pressure is applied to a predetermined area of the display surface for which the first circuit carries out the first operation in the currently displayed screen, the result being detected from the output of the output amplifier which is obtained by the first operation.

With the invention, which of the first control signal and the second control signal is to be supplied to the drive circuit can be easily determined based on whether a pressure is applied to a predetermined area of the display surface for which the first circuit carries out the first operation. Accordingly, selection of the detection operation according to a user's instruction can be easily made.

In order to solve the foregoing problems, the method of the present invention may be arranged such that the first circuit is caused to carry out the first operation so as to operate as a pressure detection circuit, and the first circuit is caused to carry out a second operation of (i) applying a third pulse to the anode of the photodiode to make the photodiode conductive in a forward direction, (ii) finishing the application of the third pulse so that a reverse biased voltage is applied to the photodiode, (iii) at a predetermined time after finishing the application of the third pulse, applying a fourth pulse to the other end of the first capacitor to change the voltage at the first node so as to enable the output amplifier to output, and (iv) while the fourth pulse is applied, obtaining the output from the output amplifier, so that the first circuit operates as an optical sensor circuit.

With the invention, the first circuit serves both as the optical sensor circuit and the pressure detection circuit. Accordingly, it is unnecessary to separately provide the optical sensor circuit and the pressure detection circuit. This enables simplifying the configuration of the display device and improving an open area ratio of a picture element.

The present invention is not limited to the description of the embodiments above, but may be altered by a skilled person within the scope of the claims. An embodiment based on a proper combination of technical means disclosed in different embodiments is encompassed in the technical scope of the present invention.

Industrial Applicability

The present invention is preferably applicable to various display devices including liquid crystal display devices.

Reference Signs List

2. Gate metal
6. Source metal
50. Liquid crystal display device (display device)
51. Display panel
62. Sensor circuit (first circuit)
62'. Sensor circuit (first circuit)
62a. TFT (output amplifier)
62b. Photodiode
62c. Capacitor (first capacitor, electrode at one end of second capacitor)
62d. Capacitor (second capacitor)
62d'. Capacitor (second capacitor)
64. Electrode (electrode at one end of second capacitor) Com. Common electrode (electrode at the other end of second capacitor)
netA. Node (first node)
Prst, Prstn. Reset pulse (first pulse, third pulse)
Prw, Prwn. Read pulse (second pulse, fourth pulse)

**Claims**

1.  A display device, comprising, in a display region, a first circuit including a photodiode, a first capacitor, a second capacitor, and an output amplifier,
    a cathode of the photodiode, one end of the first capacitor, one end of the second capacitor, and an input of the output amplifier being connected with one another via a first node,
    an electrode at the other end of the second capacitor being provided on a substrate having a display surface of a display panel, and
    an electrode at the one end of the second capacitor being positioned to be away from the display surface in a thickness direction of the display panel in such a manner as to face the electrode at the other end of the second capacitor.

2.  A display device, comprising, in a display region, a first circuit including a photodiode, a first capacitor, a second capacitor, and an output amplifier,
    a cathode of the photodiode, one end of the first capacitor, one end of the second capacitor, and an input of the output amplifier being connected with one another via a first node,
    an electrode at the other end of the second capacitor being provided on a substrate having a display surface of a display panel,
    an electrode at the one end of the second capacitor being positioned to be away from the display surface in a thickness direction of the display panel in such a manner as to face the electrode at the other end of the second capacitor,
    a first direct voltage being applied to an anode of the photodiode,
    application of the first direct voltage to the anode during a first period making the photodiode conductive in a forward direction,
    while the first direct voltage is applied to the anode during a second period following the first period, a second pulse being applied to the other end of the first capacitor to change a voltage at the first node so that a reverse biased voltage is applied to the photodiode, and
    while the second pulse is applied, an output from the output amplifier being obtained.

3.  A display device, comprising, in a display region, a first circuit including a photodiode, a first capacitor, a second capacitor, and an output amplifier,
    a cathode of the photodiode, one end of the first capacitor, one end of the second capacitor, and an input of the output amplifier being connected with one another via a first node,

an electrode at the other end of the second capacitor being provided on a substrate having a display surface of a display panel,

an electrode at the one end of the second capacitor being positioned to be away from the display surface in a thickness direction of the display panel in such a manner as to face the electrode at the other end of the second capacitor,

a first pulse being applied to an anode of the photodiode so as to make the photodiode conductive in a forward direction,

while the first pulse is applied, a second pulse being applied to the other end of the first capacitor to change a voltage at the first node so that a reverse biased voltage is applied to the photodiode, and

while the second pulse is applied, an output from the output amplifier being obtained.

4. A display device, comprising, in a display region, a first circuit including a photodiode, a first capacitor, a second capacitor, and an output amplifier,

a cathode of the photodiode, one end of the first capacitor, one end of the second capacitor, and an input of the output amplifier being connected with one another via a first node,

an electrode at the other end of the second capacitor being provided on a substrate having a display surface of a display panel,

an electrode at the one end of the second capacitor being positioned to be away from the display surface in a thickness direction of the display panel in such a manner as to face the electrode at the other end of the second capacitor,

a first pulse being applied to an anode of the photodiode so as to make the photodiode conductive in a forward direction,

during a period following a period in which the first pulse is applied, a second pulse being applied to the other end of the first capacitor to change a voltage at the first node so that a reverse biased voltage is applied to the photodiode, and

while the second pulse is applied, an output from the output amplifier being obtained.

5. The display device as set forth in any one of claims 1 to 4, wherein

the display device is a liquid crystal display device, and

the electrode at the other end of the second capacitor is a common electrode.

6. The display device as set forth in claim 5, wherein

the electrode at one end of the second capacitor is in a layer in a matrix substrate which layer is positioned to be closer to the electrode at the other end of the second capacitor than a passivation film in the matrix substrate is.

7. The display device as set forth in claim 6, wherein

the electrode at the one end of the second capacitor is a transparent electrode positioned at a same layer as a layer where picture element electrodes are positioned, and

a liquid crystal layer is positioned between the electrode at the one end of the second capacitor and the electrode at the other end of the second capacitor.

8. The display device as set forth in claim 5, wherein

the electrode at one end of the second capacitor is in a layer in a matrix substrate which layer is positioned to be farer from the electrode at the other end of the second capacitor than a passivation film in the matrix substrate is.

9. The display device as set forth in claim 8, wherein the electrode at the one end of the second capacitor is made of a gate metal.

10. The display device as set forth in claim 8, wherein the electrode at the one end of the second capacitor is made of a source metal.

11. The display device as set forth in any one of claims 4 to 10, wherein the first node is made of a gate metal.

12. The display device as set forth in any one of claims 4 to 10, wherein the first node is made of a source metal.

13. A method for driving a display device including, in a display region, a first circuit including a photodiode, a first capacitor, a second capacitor, and an output amplifier,

a cathode of the photodiode, one end of the first capacitor, one end of the second capacitor, and an input of the output amplifier being connected with one another via a first node,

an electrode at the other end of the second capacitor being provided on a substrate having a display surface of a display panel,

an electrode at the one end of the second capacitor being positioned to be away from the display surface in a thickness direction of the display panel in such a manner as to face the electrode at the other end of the second capacitor,

the method comprising causing the first circuit to carry out a first operation of (i) applying a first direct voltage to an anode of the photodiode so that application of the first direct voltage to the anode during a first period makes the photodiode conductive in a forward direction, (ii) while the first direct voltage is applied to the anode during a second period following the first period, applying a second pulse to the other end of the first capacitor to change a voltage at the first node so that a reverse biased voltage is applied to the photodiode, and (iii) while the second pulse is applied, obtaining an output from the output amplifier.

14. A method for driving a display device including, in a display region, a first circuit including a photodiode, a first capacitor, a second capacitor, and an output amplifier,

a cathode of the photodiode, one end of the first capacitor, one end of the second capacitor, and an input of the output amplifier being connected with one another via a first node,

an electrode at the other end of the second capacitor being provided on a substrate having a display surface of a display panel,

an electrode at the one end of the second capacitor being positioned to be away from the display surface in a thickness direction of the display panel in such a manner as to face the electrode at the other end of the second capacitor,

the method comprising causing the first circuit to carry out a first operation of (i) applying a first pulse to an anode of the photodiode so as to make the photodiode conductive in a forward direction, (ii) while the first pulse is applied, applying a second pulse to the other end of the first capacitor to change a voltage at the first node so that a reverse biased voltage is applied to the photodiode, and (iii) while the second pulse is applied, obtaining an output from the output amplifier.

15. A method for driving a display device including, in a display region, a first circuit including a photodiode, a first capacitor, a second capacitor, and an output amplifier,

a cathode of the photodiode, one end of the first capacitor, one end of the second capacitor, and an input of the output amplifier being connected with one another via a first node,

an electrode at the other end of the second capacitor being provided on a substrate having a display surface of a display panel,

an electrode at the one end of the second capacitor being positioned to be away from the display surface in a thickness direction of the display panel in such a manner as to face the electrode at the other end of the second capacitor,

the method comprising causing the first circuit to carry out a first operation of (i) applying a first pulse to an anode of the photodiode so as to make the photodiode conductive in a forward direction, (ii) during a period following a period in which the first pulse is applied, applying a second pulse to the other end of the first capacitor to change a voltage at the first node so that a reverse biased voltage is applied to the photodiode, and (iii) while the second pulse is applied, obtaining an output from the output amplifier.

16. The method as set forth in any one of claims 13 to 15, wherein

the display device further includes, in the display region, an optical sensor circuit which includes a light-receiving element and which detects intensity of light incident to the light-receiving element,

one of a first control signal for causing the optical sensor circuit to operate and a second control signal for causing the first circuit to carry out the first operation is selected and supplied to a drive circuit of the display device, and

with respect to a screen to be displayed next to a currently displayed screen, it is determined which of the first control signal and the second control signal is to be supplied to the drive circuit based on data of the screen to be displayed next.

17. The method as set forth in any one of claims 13 to 16, wherein

the display device further includes, in the display region, an optical sensor circuit which includes a light-receiving element and which detects intensity of light incident to the light-receiving element,

one of a first control signal for causing the optical sensor circuit to operate and a second control signal for causing the first circuit to carry out the first operation is selected and supplied to a drive circuit of the display device, and

with respect to a screen to be displayed next to a currently displayed screen, it is determined which of the first control signal and the second control signal is to be supplied to the drive circuit based on a result of whether a pressure is applied to a predetermined area of the display surface for which the first circuit carries out the first operation in the currently displayed screen, the result being detected from the output of the output amplifier which is obtained by the first operation.

18. The method as set forth in any one of claims 13 to 17, wherein
the first circuit is caused to carry out the first operation so as to operate as a pressure detection circuit, and
the first circuit is caused to carry out a second operation of (i) applying a third pulse to the anode of the photodiode to make the photodiode conductive in a forward direction, (ii) finishing the application of the third pulse so that a reverse biased voltage is applied to the photodiode, (iii) at a predetermined time after finishing the application of the third pulse, applying a fourth pulse to the other end of the first capacitor to change the voltage at the first node so as to enable the output amplifier to output, and (iv) while the fourth pulse is applied, obtaining the output from the output amplifier, so that the first circuit operates as an optical sensor circuit.

FIG. 1

(a)

(b)

FIG. 2

50

SENSING IMAGE PROCESSOR LSI/PC
(SOFTWARE ETC.)

57

SENSOR READ CIRCUIT (Vs, Vo)

55

G

Vo,Vs ····

E

DISPLAY SCANNING SIGNAL
LINE DRIVE CIRCUIT

DISPLAY PANEL

SENSOR SCANNING SIGNAL
LINE DRIVE CIRCUIT
(Vrst, Vrw)

S

····

51

DISPLAY DATA SIGNAL LINE
DRIVE CIRCUIT

52

53

56

54

POWER SOURCE CIRCUIT

F I G. 3

(a)

Com

72

Ccvr (off)

LC

d (off)

netA

62

71

(b)

62

Com    Vsm    Vom

Ccvr (off)   (SMALL)        62a

62d

netA

62b        Cst        62c

Vrstn        Vrwn

F I G. 4

(a)

(b)

F I G . 5

F I G . 6

F I G. 7

F I G . 8

F I G . 9

F I G . 1 0

# F I G. 1 1

F I G. 1 2

A - - - - - - - - - - - - - - - - - - - - - - - - - - - - - - - - - - - - - - - - - ➤ A'

20 ─┄ · · · · ·
1
20  ⎫
Com(TM) ⎬ 72
⎭

· · · ⭕⭕⭕⭕⭕ · · ·    ~ LC

5  61  4
8a

63(TM) ─┄
61s(6) ─┄
3 ─┄
61d(6)
71 ⎫
⎬
⎭
1

61g(2)    7    Csn(2)

F I G. 1 3

B - - - - - - - - - - - - - - - - - - - - - - - - - - - - - - - - - ➤ B'

21 ─┄
1
21  ⎫
Com(TM) ⎬ 72
⎭

· · · ⭕⭕⭕⭕⭕ · · ·    ~ LC

5
62bd(6)
8b

62b ─┄
62b
7  ⎫
3 ─┄
71 ⎬
1  ⎭

62bs(6)  4  Vrstn(2)

F I G. 1 4

C - - - - - - - - - - - - - - - - - - - - - - - - - - - - - - - - - - - - - - - - - - - - - - - - - - - - - - ➤ C'

1
21  ⎫
Com(TM) ⎬ 72
⎭

Vsm     Vom
(62ad,6) (62as,6) · · ·
62d'
62ca(6)
~ LC

⭕⭕⭕⭕
⭕⭕⭕⭕
⭕⭕⭕⭕

8c
62bs(6)  8d'

62a ─┄
7  ⎫
⎬ 71
1  ⎭

5  62ag(2)  4  3  Sm+1  Vrwn  62c   Sm+2(6)     netA(2)
(6)   (2)      netA(2)

F I G. 1 5

FIG. 16

FIG. 17

FIG. 18

FIG.19

FIG. 20

FIG. 21

FIG. 22

FIG. 23

FIG. 24

(1) START TO EXECUTE SCANNER SOFTWARE

(2)

(2') | abcde |

(3)

(3')

(4) START TO EXECUTE MUSIC-PLAYING SOFTWARE

(5)

(5')

(6)

(6')

F I G. 2 5

```
                    ┌─────────┐
                    │  START  │
                    └─────────┘
                         │
                    ┌────────────────┐  S11
                   ╱│  SCANNER        │╲
         NO       ╱ │  FUNCTION/TOUCH │ ╲
   ◄────────────── │  PANEL FUNCTION IS │
                  ╲ │  REQUIRED?       │ ╱
                   ╲│                 │╱
                    └────────────────┘
                         │ YES
                    ┌────────────────┐  S12
                   ╱│  WHAT MODE      │╲
                  ╱ │  SIGNAL IS REQUIRED │╲
                  │ │  FOR STARTED APPLICATION │
                  ╲ │  SOFTWARE       │ ╱
                   ╲│                 │╱
                    └────────────────┘
                         │
                 ┌──────────────────────┐  S13
                 │  SELECT MOST SUITABLE │─────────────► s1
                 │  MODE CONTROL SIGNAL  │
                 └──────────────────────┘
                         │
                 ┌──────────────────────┐  S14
                 │ OBTAIN/CALCULATE SENSED IMAGE │
                 │ (LIGHT)/DATA (CAPACITANCE)    │
                 └──────────────────────┘
                         │
                    ┌────────────────┐  S15         NO
                   ╱│  INPUT POINT    │╲ ─────────────►
                   ╲│  EXISTS?        │╱
                    └────────────────┘
                         │ YES
                    ┌────────────────┐  S16
                   ╱│  WHAT IS NUMBER │╲
                  ╱ │  (m)/POSITION(xn, yn) OF │╲
                  ╲ │  SENSING POINT? │ ╱
                   ╲│                 │╱
                    └────────────────┘
                         │
                 ┌──────────────────────┐  S17
                 │ PROCESS CORRESPONDING │
                 │ TO NUMBER(m) AND      │
                 │ POSITION(xn, yn) OF INPUT POINT │
                 └──────────────────────┘
                         │
                    ┌─────────┐
                    │   END   │
                    └─────────┘
```

FIG. 26

F I G. 2 7

DETECTION OF PRESSURE

(1) NOT PRESSURED

(2) PRESSURED

DETECTION OF LIGHT

(3) TOUCHED (PRESSURED)

(1')

(2')

(3')

F I G. 2 8

```
                    ( START )
                        │
                        ▼
        NO         S21
    ◄────────  LIGHT
              DETECTION/PRESSURE
              DETECTION IS
              REQUIRED?
                        │
                      YES
                        │
                        ▼
                             S22
              STARTED APPLICATION           NO      s1 FOR LIGHT
              SOFTWARE REQUIRES LIGHT      ─────►   DETECTION DRIVE
              DETECTION MEANS
              SUCH AS SCANNER?
                        │
                      YES                           s1 FOR PRESSURE
                        │                  ─────►   DETECTION DRIVE
                        ▼
         OBTAIN/CALCULATE SENSING DATA     S23
              (CAPACITANCE)
                        │
                        ▼
                             S24
                                      NO
         INPUT POINT EXISTS?
                        │
                      YES                           s1 FOR LIGHT
                        │                  ─────►   DETECTION DRIVE
                        ▼
              OBTAIN/CALCULATE            S25
              SENSED IMAGE (LIGHT)
                        │
                        ▼
              PROCESSES ACCORDING TO      S26
              SENSED IMAGE
                        │
                        ▼
                    ( END )
```

FIG. 29

F I G. 3 0

<table>
<tr><td colspan="2"><b>INTERNATIONAL SEARCH REPORT</b></td><td>International application No.<br>PCT/JP2009/068399</td></tr>
</table>

| A. CLASSIFICATION OF SUBJECT MATTER |
|---|
| $G02F1/135$(2006.01)i, $G02F1/133$(2006.01)i, $G02F1/1333$(2006.01)i, $G06F3/041$ (2006.01)i, $G09F9/30$(2006.01)i, $G09G3/20$(2006.01)i, $G09G3/36$(2006.01)i |

According to International Patent Classification (IPC) or to both national classification and IPC

| B. FIELDS SEARCHED |
|---|
| Minimum documentation searched (classification system followed by classification symbols)<br>G02F1/135, G02F1/133, G02F1/1333, G06F3/041, G09F9/30, G09G3/20, G09G3/36 |

Documentation searched other than minimum documentation to the extent that such documents are included in the fields searched

| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2009-036946 A (Seiko Epson Corp.),<br>19 February 2009 (19.02.2009),<br>entire text; all drawings<br>& US 2009/0033850 A1 & CN 101359111 A<br>& KR 10-2009-0013711 A | 1-18 |
| A | JP 2008-027292 A (Toshiba Matsushita Display Technology Co., Ltd.),<br>07 February 2008 (07.02.2008),<br>entire text; all drawings<br>& US 2008/0018612 A1 | 1-18 |
| A | WO 2008/126768 A1 (Sharp Corp.),<br>23 October 2008 (23.10.2008),<br>entire text; all drawings<br>(Family: none) | 1-18 |

☐ Further documents are listed in the continuation of Box C.  ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>25 December, 2009 (25.12.09) | Date of mailing of the international search report<br>12 January, 2010 (12.01.10) |
|---|---|
| Name and mailing address of the ISA/<br>Japanese Patent Office | Authorized officer |
| Facsimile No. | Telephone No. |

Form PCT/ISA/210 (second sheet) (April 2007)

**EP 2 416 214 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2007145347 A